(19) Europäisches Patentamt / European Patent Office / Office européen des brevets

(11) **EP 2 597 694 A2**

(12) **EUROPEAN PATENT APPLICATION**

(43) Date of publication:
**29.05.2013 Bulletin 2013/22**

(51) Int Cl.:
***H01L 51/00*** (2006.01)   ***H01L 51/10*** (2006.01)

(21) Application number: **12193796.5**

(22) Date of filing: **22.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **22.11.2011 JP 2011255279**

(71) Applicant: **Fujifilm Corporation**
**Minato-ku**
**Tokyo 106-8620 (JP)**

(72) Inventor: **Katsumura, Manabu**
**Kanagawa, 258-8577 (JP)**

(74) Representative: **HOFFMANN EITLE**
**Patent- und Rechtsanwälte**
**Arabellastrasse 4**
**81925 München (DE)**

(54) **Conductive pattern forming method and conductive pattern forming system**

(57)     According to a mode of the present invention, since a conductive pattern (a source wiring (3) and a drain wiring (4)) having a graded composition structure in which a content ratio of a conductive polymer decreases while a content ratio of metal nanoparticles increases from a base material (a flexible film (1) and an organic TFT (2)) is formed with respect to a thickness direction, adhesion with the base material is secured at a bonding portion between the base material and the conductive pattern due to the high content ratio of the conductive polymer and, at the same time, favorable electrical performance is produced by increasing the content ratio of the metal nanoparticles.

FIG.1

**Description**

BACKGROUND OF THE INVENTION

Field of the Invention

The present invention relates to a conductive pattern forming method and a conductive pattern forming system and, more specifically, to wiring formation and conductive film formation on a flexible material such as organic resin using an ink-jet method.

Description of the Related Art

In recent years, proposals have been made in regards to wiring drawing according to printable electronics using printing technology. Japanese Patent Application Publication No. 2004-302392 discloses a method of manufacturing an organic EL display device in which a functional fluid prepared by dispersing metal particles in a conductive polymer is applied to a flexible and irreversible resin substrate (a flexible substrate) in order to form wirings such as a power line, a signal line, a scanning line, active elements such as a transistor, and light-emitting pixels.
In addition, Japanese Patent Application Publication No. 6-93418 discloses a technique for forming an ultrafine particle film pattern containing metal microparticles using a gas deposition method. Specific examples of an ultrafine particle film pattern cited in Japanese Patent Application Publication No. 6-93418 include an ultrafine particle film pattern composed of a lower layer made of a material having good adhesion with an electrode and an upper layer having necessary characteristics, and an ultrafine particle film pattern provided with a graded composition from a lower layer to an upper layer.

SUMMARY OF THE INVENTION

However, with the functional fluid prepared by dispersing metal particles in a conductive polymer which is used in the method of manufacturing an organic EL display device disclosed in Japanese Patent Application Publication No. 2004-302392, a bonding performance (adhesion) with a resin substrate and flexibility become an issue if a content of metal particles is increased in order to improve electrical performance. On the other hand, reducing the content of metal particles results in lower electrical conductivity (conductivity) and electrical performance becomes an issue.
In addition, since the technique for forming an ultrafine particle film pattern disclosed in Japanese Patent Application Publication No. 6-93418 uses a mask, steps for forming the mask and removing the mask become essential.
The present invention has been made in consideration of the circumstances described above and an object thereof is to provide a conductive pattern forming method and a conductive pattern forming system capable of forming a conductive pattern which does not require a mask, which is adhesive with a substrate, and which provides favorable electrical performance.
In order to achieve the above object, a conductive pattern forming method according to the present invention comprises the steps of: forming a first pattern on a base material by discharging, from a first ink-jet head, a first functional fluid containing a conductive polymer or containing the conductive polymer and metal microparticles at a predetermined content ratio; forming a second pattern on the first pattern by discharging, from a second ink-jet head, a second functional fluid which contains the conductive polymer and the metal microparticles and in which a content ratio of the conductive polymer is reduced and a content ratio of the metal microparticles is increased with respect to the first functional fluid; and forming a third pattern on the second pattern by discharging, from a third ink-jet head, a third functional fluid which contains the conductive polymer and the metal microparticles and in which the content ratio of the conductive polymer is reduced and the content ratio of the metal microparticles is increased with respect to the second functional fluid, wherein a conductive pattern is formed which at least includes the first pattern, the second pattern, and the third pattern and which has a graded composition in which the content ratio of the conductive polymer is reduced and the content ratio of the metal microparticles is increased from the base material with respect to a thickness direction using three or more types of functional fluids which have different content ratios of the conductive polymer and the metal microparticles.
According to the present invention, since a conductive pattern having a graded composition structure in which a content ratio of a conductive polymer decreases while a content ratio of metal microparticles increases from a base material is formed with respect to a thickness direction, adhesion with the base material is secured at a bonding portion between the base material and the conductive pattern due to the high content ratio of the conductive polymer and, at the same time, favorable electrical performance is produced by increasing the content ratio of the metal microparticles.

BRIEF DESCRIPTION OF THE DRAWINGS

The nature of this invention, as well as other objects and advantages thereof, will be explained in the following with reference to the accompanying drawings, in which like reference characters designate the same or similar parts throughout the figures and wherein:

FIG. 1 is an explanatory diagram of a conductive pattern forming method according to a first embodiment of the present invention;

FIG. 2 is a plan view of a conductive pattern shown in FIG. 1;

FIG. 3 is a schematic configuration diagram of the conductive pattern shown in FIG. 1;

FIG. 4 is a general configuration diagram of a pattern forming system according to the first embodiment (ink-mixing method) of the present invention;

FIG. 5 is a block diagram of the pattern forming system shown in FIG. 4;

FIG. 6 is a block diagram showing a schematic configuration of a control system in the pattern forming system shown in FIGS. 4 and 5;

FIG. 7 is a flow chart showing a flow of conductive pattern formation using an ink-mixing method;

FIGS. 8A to 8C are explanatory diagrams each schematically illustrating a graded composition pattern forming step shown in FIG. 7;

FIGS. 9A and 9B are explanatory diagrams each showing a relationship among a droplet diameter, a dot diameter, and a dot pitch, wherein FIG. 9A is a diagram showing a base material from a side surface side and FIG. 9B is a diagram showing the base material from an upper side;

FIG. 10 is a graph showing a relationship between a base material temperature and a pattern width of a functional fluid;

FIG. 11 is a graph showing a relationship between a boiling point of a solvent and pattern width;

FIG. 12 is a graph showing a relationship between dot pitch and pattern width;

FIG. 13 is an explanatory diagram of a planar shape of a pattern of a functional fluid;

FIG. 14 is an explanatory diagram of a planar shape and a three-dimensional shape of a functional fluid;

FIGS. 15A to 15C are an explanatory diagrams each illustrating an effect of volatility of a mixed solvent on a surface shape of a dot (pattern);

FIG. 16 is an explanatory diagram showing a planar shape of a pattern of a laminated functional fluid;

FIG. 17 is a general configuration diagram of a conductive pattern forming system according to a second embodiment (draw-mixing method) of the present invention;

FIG. 18 is a block diagram showing a schematic configuration of a pattern forming system shown in FIG. 17;

FIGS. 19A to 19C are explanatory diagrams each illustrating conductive pattern formation using a draw-mixing method;

FIGS. 20A to 20D are explanatory diagrams each illustrating discharge control according to a draw-mixing method;

FIGS. 21A to 21D are explanatory diagrams each illustrating another discharge control according to a draw-mixing method;

FIG. 22 is a sectional perspective view of a touch panel showing an application example of a conductive pattern forming method according to the present invention;

FIG. 23 is an explanatory diagram of pad formation according to an application example of the present invention;

FIGS. 24A to 24D are explanatory diagrams each illustrating discharge control for pad formation according to a draw-mixing method;

FIGS. 25A and 25B are explanatory diagrams each illustrating a sequence of dot arrangement according to a draw-mixing method;

FIGS. 26A to 26C are explanatory diagrams each illustrating a semi-drying process;

FIGS. 27A to 27C are other explanatory diagrams each illustrating a semi-drying process;

FIGS. 28A to 28C are other explanatory diagrams each illustrating a semi-drying process;

FIGS. 29A to 29C are other explanatory diagrams each illustrating a semi-drying process;

FIGS. 30A and 30B are explanatory diagrams each illustrating a surface modification process for pad formation according to a present application example;

FIGS. 31A to 31C are explanatory diagrams each illustrating edge frame formation for pad formation according to a present application example;

FIGS. 32A and 32B are explanatory diagrams each illustrating a head length of an ink-jet head;

FIG. 33 is an explanatory diagram of an example of a drawing trace measure;

FIGS. 34A to 34C are explanatory diagrams each illustrating another example of a drawing trace measure;

FIGS. 35A to 35E are explanatory diagrams each showing an example of electrode formation using four types of materials; and

FIG. 36 is a schematic configuration diagram showing another device configuration example according to the present

invention.

<u>DESCRIPTION OF THE PREFERRED EMBODIMENTS</u>

[First embodiment]

(Overview of conductive pattern forming method (system))

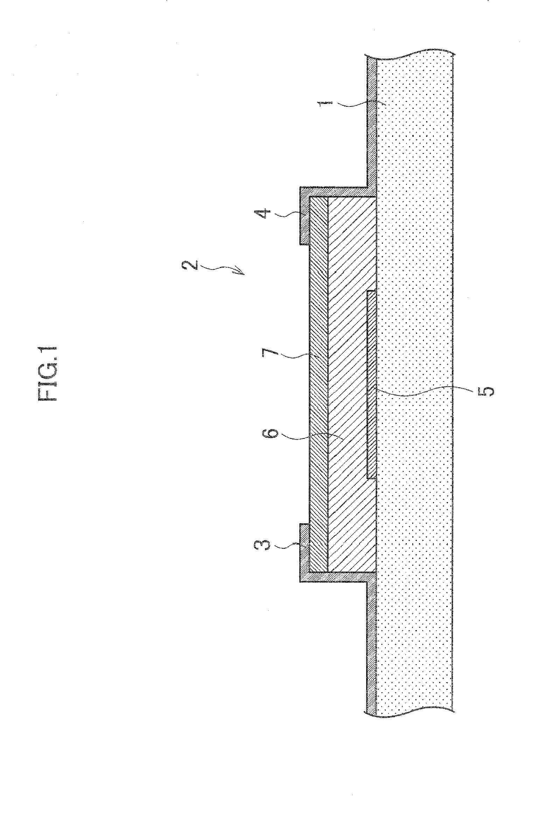

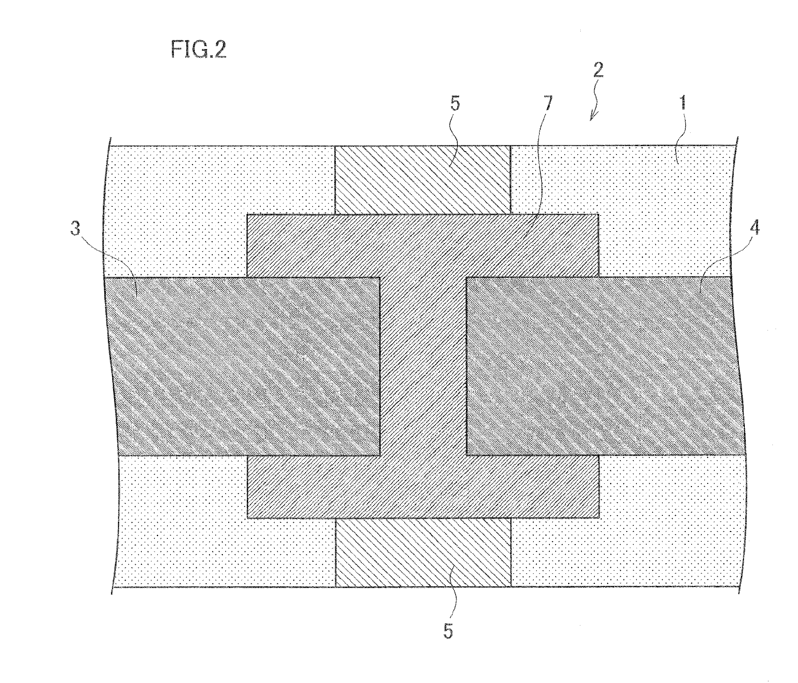

FIG. 1 is an explanatory diagram of a conductive pattern forming method (system) according to a first embodiment of the present invention and is a sectional view showing a schematic structure of electrical wirings (electrodes or electrode wirings) 3, 4, and 5 of an organic TFT (Thin Film Transistor) 2 formed on a flexible film (flexible base material) 1.
In the first embodiment described below, a description will be given on conductive pattern formation according to an ink-mixing method in which a conductive polymer and metal nanoparticles are mixed in advance at a predetermined content ratio and a plurality of functional fluids with different content ratios of the conductive polymer and the metal nanoparticles are used.
Note that in the present specification, the "flexible film 1" and the "organic TFT 2" may also be collectively referred to as a "base material" without distinction between the "flexible film 1" and the "organic TFT 2". In other words, a source wiring 3 and a drain wiring 4 shown in FIG. 1 have portions formed on an organic semiconductor layer 7 of the organic TFT 2 and portions formed on the flexible film 1, wherein "electrical wiring formed on the base material" includes both a portion formed on the organic semiconductor layer 7 of the organic TFT 2 and a portion formed on the flexible film 1.
In addition, "electrical wiring" includes both a conductive pattern formed in a same plane of the flexible film 1 and a conductive pattern penetrating the flexible film 1, and electrically connects connected bodies that are mounted on the flexible film 1.
Furthermore, FIG. 2 is a plan view of the conductive pattern shown in FIG. 2 and is a view from a side of a surface of the flexible film 1 on which the organic TFT 2 and the wirings 3, 4, and 5 are formed.
The wiring 3 shown in FIGS. 1 and 2 is a source wiring connected to a source (not illustrated) of the organic TFT 2, and the wiring 4 is a drain wiring connected to a drain (not illustrated) of the organic TFT 2. In addition, the wiring 5 is a gate wiring connected to a gate (not illustrated) of the organic TFT 2.
The source wiring 3, the drain wiring 4, and the gate wiring 5 are connected to a drive circuit (not illustrated; including a drive IC terminal, a power supply terminal, and a GND terminal) and other active elements, passive elements, other electrodes and terminals, and the like.
For example, when the organic TFT 2 is applied to a liquid crystal panel, the source wiring 3 is connected to a source bus, the drain wiring 4 is connected to a pixel electrode, and the gate wiring 5 is connected to a gate bus.
While a detailed structure of the organic TFT 2 shown in FIGS. 1 and 2 is not illustrated, the organic TFT 2 has a gate oxide film 6 and the organic semiconductor layer 7, and the gate is a bottom-contact type gate while the source and the drain are a top-contact type source and a top-contact type drain.
The source wiring 3 and the drain wiring 4 shown FIGS. 1 and 2 have a graded composition containing a conductive polymer and metal nanoparticles.

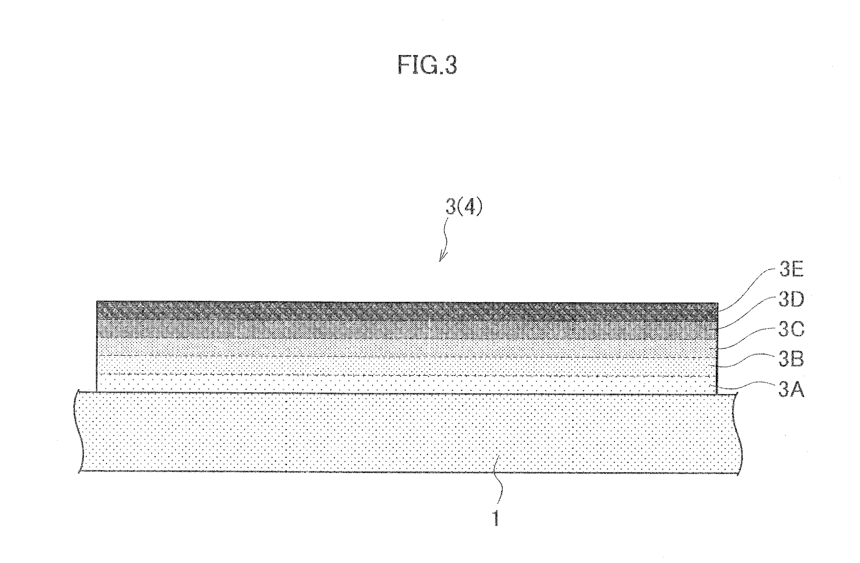

FIG. 3 is a schematic configuration diagram of the conductive pattern (the source wiring 3 and the drain wiring 4) shown in FIG. 1. The source wiring 3 and the drain wiring 4 formed on the organic TFT 2 (the flexible film 1) have a graded composition in which functional fluids with different content ratios of the conductive polymer and the metal nanoparticles are overlapped on each other and a content ratio of the conductive polymer is reduced while a content ratio of the metal microparticles is increased with respect to a thickness direction of the source wiring 3 and the drain wiring 4 from the base material (the flexible film 1 and the organic TFT 2).
In other words, with the source wiring 3 (the drain wiring 4) shown in FIG. 3, a second functional fluid 3B containing the conductive polymer at a content ratio of 80% and the metal nanoparticles at a content ratio of 20% is overlaid on top of a first functional fluid 3A containing only the conductive polymer (a content ratio of the conductive polymer is 100% and a content ratio of the metal nanoparticles is 0%) and, in turn, a third functional fluid 3C containing the conductive polymer at a content ratio of 60% and the metal nanoparticles at a content ratio of 40% is overlaid on top of the second functional fluid 3B.
Furthermore, a fourth functional fluid 3D containing the conductive polymer at a content ratio of 40% and the metal nanoparticles at a content ratio of 60% is overlaid on top of the third functional fluid 3C and, in turn, a fifth functional fluid 3E containing the conductive polymer at a content ratio of 20% and the metal nanoparticles at a content ratio of 80% is overlaid on top of the fourth functional fluid 3D.
In this manner, a plurality of types of functional fluids containing the conductive polymer and the metal nanoparticles at different content ratios are overlaid on each other, and interlayer diffusion of the conductive polymer and the metal nanoparticles is performed in a vicinity of boundaries between the respective functional fluid patterns (layers) to realize a graded composition of the conductive polymer and the metal nanoparticles. Note that dashed lines illustrated in FIG. 3 conveniently represent boundaries between the respective fluids.

A mode can also be adopted in which an outermost surface of the source wiring 3 (the drain wiring 4) shown in FIG. 3 is covered by metal by further applying a sixth functional fluid containing the conductive polymer at a content ratio of 0% and the metal nanoparticles at a content ratio of 100% on top of the source wiring 3 (the drain wiring 4).

In addition, a mode in which the first functional fluid 3A is adjusted to contain a small amount (around several percent) of the metal nanoparticles by setting the content ratio of the conductive polymer to less than 100% and a mode in which the first functional fluid 3A containing the conductive polymer at a content ratio of 100% is omitted and the second functional fluid 3B containing the conductive polymer at a content ratio of 80% and the metal nanoparticles at a content ratio of 20% is discharged on the base material can also be adopted.

Moreover, a mode which uses the first functional fluid 3A containing the conductive polymer at a content ratio of 100% is favorable from the perspective of realizing a strong bonding state with the organic TFT 2 (the flexible film 1).

On the other hand, a problem in terms of flexibility may arise when the outermost surface of the source wiring 3 (the drain wiring 4) is solely covered by metal. Therefore, when flexibility is required such as in a case where the flexible film after forming the source wiring 3 (the drain wiring 4) is to be rolled up, a mode is favorable in which a functional fluid of an uppermost layer that is last overlapped contains the conductive polymer.

Although details will be given later, the source wiring 3 and the drain wiring 4 illustrated in FIG. 3 have minute widths of several ten micrometers which correspond to a diameter of one dot (one dot width) formed by a functional fluid discharged according to an ink-jet method.

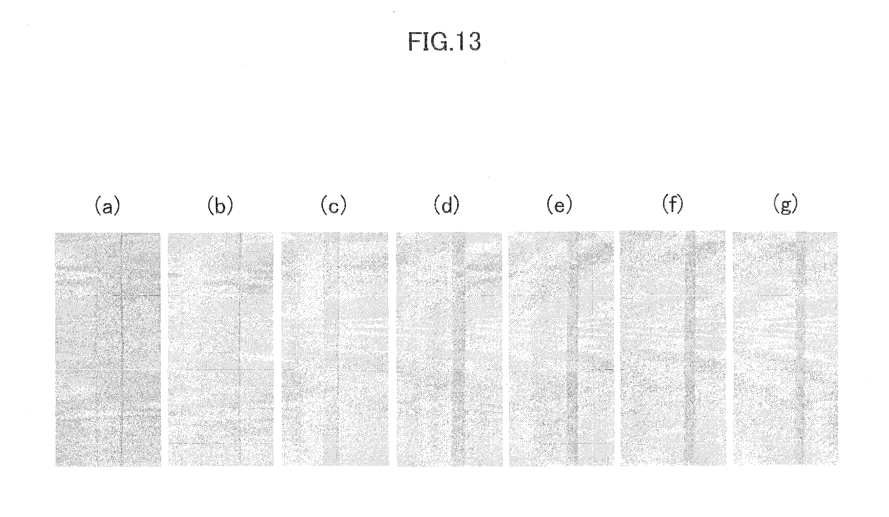

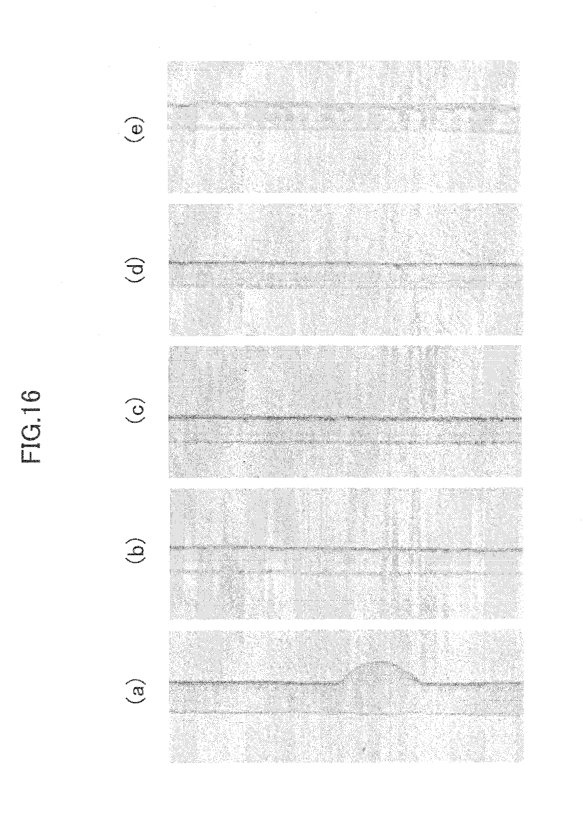

In addition, a conductive pattern is obtained which has a uniform width and in which a bulge (a phenomenon where a width of a part of a pattern is wider than other parts; refer to (a) of FIG. 16) and a jaggy (a phenomenon where irregularities attributable to a circular shape of dots occur at edges of a wiring; refer to (f) of FIG. 13) have not occurred.

As the flexible film 1, for example, PET (polyethylene terephthalate) with a thickness of 500 micrometers can be used. Other materials which can be used as the flexible film 1 include resin materials that can be made into extensible and irreversible films such as PEN (polyethylene naphthalate), polyimide, polycarbonate, polyarylate, polyacrylonitrile, and polyethersulfone.

Furthermore, the thickness of the flexible film 1 can be set to within a range of several ten micrometers to several millimeters according to intended usage.

While the present invention is applied to the formation of the source wiring 3 and the drain wiring 4 of the top-contact organic TFT 2 in the present example, the present invention can also be applied to a gate wiring of the top-contact organic TFT 2 or a source wiring, a drain wiring, and a gate wiring of a bottom-contact organic TFT.

PEDOT (polyethylenedioxythiophene) is used as the conductive polymer that is a component of the graded composition. PEDOT can be dispersed in an aqueous solvent and an organic solvent and be applied on a base material using an ink-jet method, and is capable of producing favorable electrical conductivity of around $1 \times 10^{-5}$ siemens per centimeter (S/cm) after removal of a solvent component.

An aqueous dispersion made of a PEDOT-PSS compound prepared by adding polyanionic poly(styrenesulfonate) is used as an aqueous solvent in which PEDOT is dispersed to prepare a conductive polymer application fluid.

PEDOT-PSS is a polymer complex in which PEDOT (polymer of 3,4-ethylenedioxythiophene) and PSS (polymer of styrenesulfonic acid) coexist, and by using PSS (polystyrene sulfonate) that is a hydrosoluble and highly acidic polymer as a dopant, PEDOT-PSS can be dispersed in water and applied on material as weak as organic solvents.

In addition, examples of an organic solvent in which PEDOT is dispersed to prepare a conductive polymer application fluid include nitromethane and propylene carbonate. The PEDOT in the organic solvent disperses as a polymer.

A functional fluid including PEDOT and which is dischargeable according to an ink-jet method is configured so as to include PEDOT and a solvent of PEDOT as solute components, a dispersant for dispersing PEDOT, and a surfactant for adjusting surface tension, and is adjusted to a viscosity that enables discharge according to an ink-jet method.

Examples of other conductive polymers include polyaniline, polyparaphenylene, polypyrrole, polythiophene, poly(p-phenylenevinylene), polyazyl, and pentacene.

A functional fluid containing the conductive polymer demonstrates predetermined electrical performance when solutes are physically bonded and further chemically bonded due to evaporation of the solvent component.

Silver (Ag) nanoparticles with a particle size (diameter) of 5 nanometers to 300 nanometers are used as the metal nanoparticles that are another component of the graded composition. Other metallic materials which can be used as the metal nanoparticles include gold (Au), copper (Cu), lead (Pb), nickel (Ni), and electrically conductive oxides such as indium tin oxide ITO), zinc oxide (ZnO), and aluminum (Al)-added zinc oxide.

Moreover, when copper is used as the metal nanoparticles, the source wiring 3 and the drain wiring 4 are formed under an environment of inert gas (such as nitrogen or argon) in order to prevent oxidation of copper.

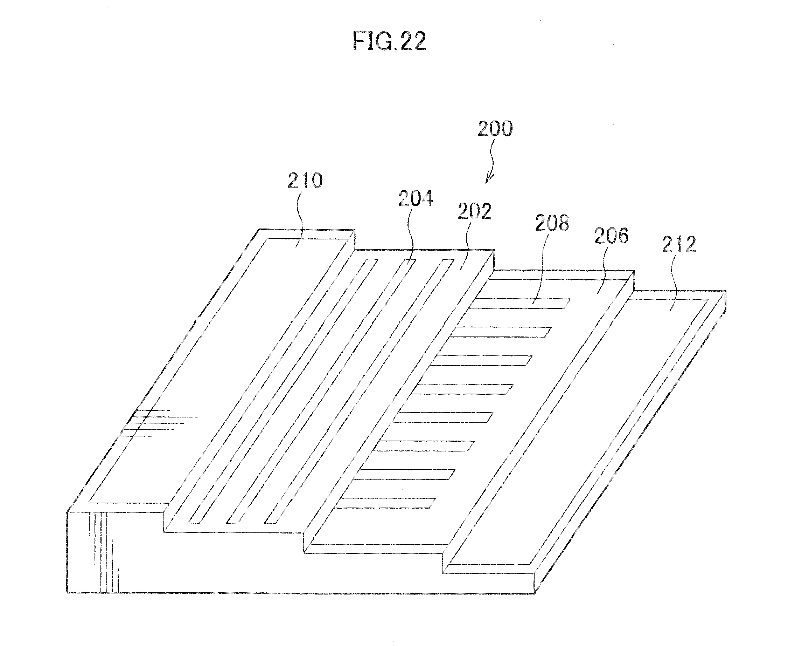

Indium tin oxide is colorless and transparent, and when combined with a transparent conductive polymer, a transparent wiring and a transparent electrode can be formed. The transparent wiring (electrode) is applied to a touch panel display device (refer to FIG. 22).

When a film solely composed of metal nanoparticles (for example, silver nanoparticles) is formed on the organic TFT 2, an organic/inorganic dissimilar interface is formed which is incapable of providing strong adhesion.

On the other hand, when a film of a conductive polymer (for example, PEDOT) is formed on the organic TFT 2, since an organic/inorganic interface is formed, stronger adhesion is provided compared to a case where a film solely composed of metal nanoparticles is formed.

In other words, from the perspective of bonding between the organic TFT 2 and the source wiring 3 (the drain wiring 4), a bonding portion of the organic TFT 2 and the source wiring 3 (the drain wiring 4) favorably contains a conductive polymer.

From the perspective of conductivity (electrical performance), a film mixed with metal nanoparticles has a higher electrical conductivity than a film solely composed of a conductive polymer. In addition, the greater a ratio of metal nanoparticles to the conductive polymer, the higher the electrical conductivity.

In other words, from the perspective of a contact with the organic TFT 2 (the flexible film 1), a content ratio of the conductive polymer is increased at a bonding portion between the source wiring 3 (the drain wiring 4) illustrated in FIG. 3 and the organic TFT 2 (the flexible film 1). As a result, a strong bonding state is realized while securing an electrically-bonded state.

On the other hand, from the perspective of securing favorable electrical performance, the content ratio of the metal nanoparticles is set so that the greater a thickness from the organic TFT 2 (the flexible film 1), the higher the content ratio of the metal nanoparticles. As a result, since the further upward in a thickness direction, the higher the electrical conductivity of the source wiring 3 (the drain wiring 4), favorable electrical performance is secured.

(Description of conductive pattern forming system (device))

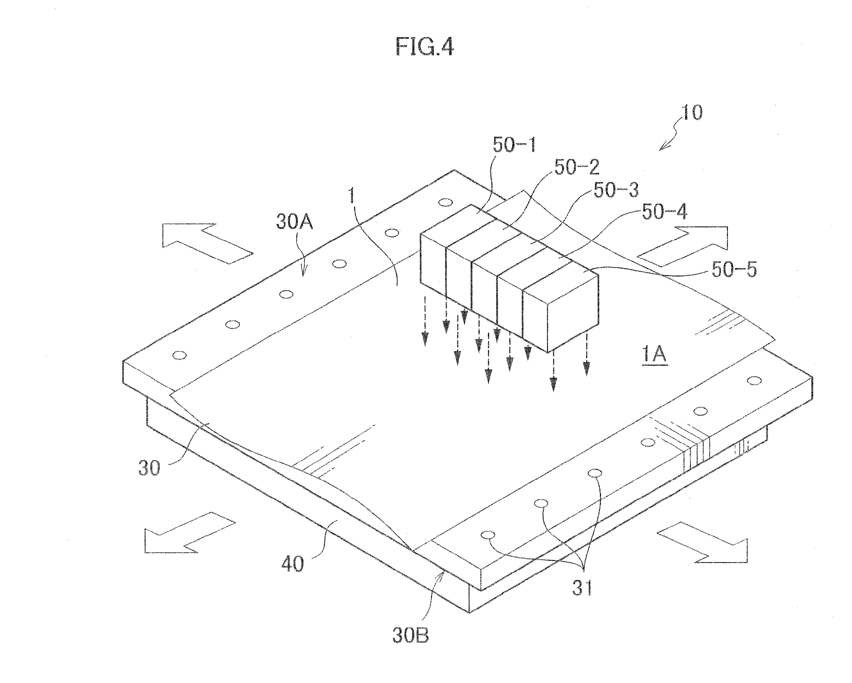

Next, a conductive pattern forming system (device) according to the first embodiment of the present invention will be described. FIG. 4 is a general configuration diagram of a pattern forming system according to the first embodiment of the present invention.

A conductive pattern forming system 10 shown in FIG. 4 is of a flat head type and the ink-mixing method described earlier is applied thereto.

The conductive pattern forming system 10 shown in FIG. 4 is configured so as to include a stage 30 on which the flexible film 1 is placed, a suction chamber 40 for suctioning and holding the flexible film 1 placed on the stage 30, and ink-jet heads 50-1, 50-2, 50-3, 50-4, and 50-5 which discharge respective functional fluids toward the flexible film 1.

Note that, in the following description, the ink-jet heads 50-1, 50-2, 50-3, 50-4, and 50-5 may sometimes be referred to as an "ink-jet head 50" without distinction among the ink-jet heads 50-1, 50-2, 50-3, 50-4, and 50-5.

The stage 30 has a greater width than a maximum width of the flexible film 1 and is configured so as to be freely movable in a horizontal direction due to a transfer mechanism (not illustrated). For example, a rack-and-pinion mechanism, a ball screw mechanism, and the like can be used as the transfer mechanism.

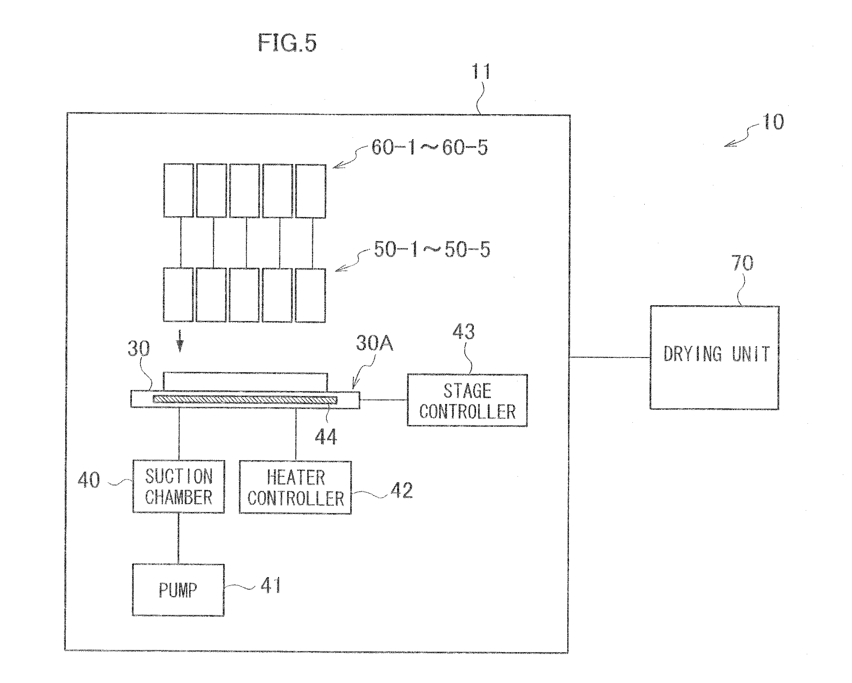

The stage 30 can be moved to a desired position by controlling an operation of the transfer mechanism using a stage controller (not illustrated in FIG. 4; denoted by reference numeral 43 in FIG. 5). Outline arrows illustrated in FIG. 4 represent directions in which the stage 30 is movable.

The ink-jet head 50 is supported by a supporting member (not illustrated) so that there is a constant clearance between the ink-jet head 50 and the flexible film 1 (the stage 30). Moreover, the ink-jet head 50 may be moved in a horizontal plane that is parallel to a pattern forming surface 1A of the flexible film 1 (the stage 30) while keeping the flexible film 1 fixed, or both the flexible film 1 (the stage 30) and the ink-jet head 50 may be moved in the horizontal plane.

In the stage 30 shown in FIG. 4, a large number of suction holes 31 are formed on a holding surface 30A of the flexible film 1. The suction chamber 40 is provided on an opposite-side surface 30B to the holding surface 30A of the flexible film 1 on the stage 30, and as a result of the suction chamber 40 being vacuum-suctioned by a pump (not illustrated in FIG. 4; denoted by reference numeral 41 in FIG. 5), the flexible film 1 on the stage 1 is suctioned and held.

In addition, a heater (not illustrated in FIG. 4; denoted by reference numeral 44 in FIG. 5) is built into the stage 30, and due to control by a heater controller (not illustrated in FIG. 4; denoted by reference numeral 42 in FIG. 5), heating can be performed so that a temperature of the flexible film 1 suctioned and held by the stage 30 falls within a range set in advance.

Each of the ink-jet heads 50-1 to 50-5 shown in FIG. 4 is supplied with a functional fluid having a different content ratio of the conductive polymer and the metal nanoparticles from each functional fluid tank (not illustrated in FIG. 4; denoted by reference numerals 60-1 to 60-5 in FIG. 5) and discharges the functional fluid to the pattern forming surface 1A of the flexible film 1 to form a predetermined pattern.

For example, the ink-jet head 50-1 may discharge a first functional fluid containing the conductive polymer at a content ratio of 100% and the metal nanoparticles at a content ratio of 0%, the ink-jet head 50-2 may discharge a second functional fluid containing the conductive polymer at a content ratio of 80% and the metal nanoparticles at a content ratio of 20%, the ink-jet head 50-3 may discharge a third functional fluid containing the conductive polymer at a content ratio of 60% and the metal nanoparticles at a content ratio of 40%, the ink-jet head 50-4 may discharge a fourth functional fluid containing the conductive polymer at a content ratio of 40% and the metal nanoparticles at a content ratio of 60%, and the ink-jet head 50-5 may discharge a fifth functional fluid containing the conductive polymer at a content ratio of 20% and the metal nanoparticles at a content ratio of 80%.

While a mode including five ink-jet heads 50-1 to 50-5 respectively with different content ratios of the conductive polymer and the metal nanoparticles is shown in FIG. 4, three or more ink-jet heads 50 may suffice.

Various systems such as a piezoelectric system, a thermal system, and a continuous system can be applied to the ink-jet head 50 shown in FIG. 4. The piezoelectric system is a system in which a piezoelectric element is provided on a wall constituting a pressure chamber that communicates with a nozzle, and by deforming the pressure chamber due to a deflective deformation of the piezoelectric element, a fluid in the pressure chamber is discharged from the nozzle.

The thermal system is a system in which a fluid in a fluid chamber is heated and the fluid is discharged from a nozzle by utilizing a film boiling phenomenon of the fluid. In addition, possible nozzle arrangements of the ink-jet head 50 include a single row arrangement in which a plurality of nozzles is arranged in a single row, a staggered arrangement in which a plurality of nozzles is arranged in a staggered manner in two rows, and a matrix arrangement in which a plurality of nozzles is arranged two-dimensionally.

FIG. 5 is a block diagram of the conductive pattern forming system 10 shown in FIG. 4. As shown in FIG. 5, the functional fluid tanks 60-1, 60-2, 60-3, 60-4, and 60-5 are respectively communicated with the ink-jet heads 50-1, 50-2, 50-3, 50-4, and 50-5 via predetermined fluid flow channels (tubes), and functional fluids having different content ratios of the conductive polymer and the metal nanoparticles are sent from the functional fluid tanks 60-1, 60-2, 60-3, 60-4, and 60-5 to respectively corresponding ink-jet heads 50-1, 50-2, 50-3, 50-4, and 50-5.

Suction pressure is applied to the flexible film 1 held by the holding surface 30A of the stage 30 from the pump 41 via the suction chamber 40. In other words, movement of the stage 30 holding the flexible film 1 is controlled by the stage controller 43 in correspondence with the discharge of functional fluids by the ink-jet heads 50-1, 50-2, 50-3, 50-4, and 50-5.

An amount of heating performed by the heater 44 built into the stage 30 is controlled by the heater controller 42 according to a preset temperature of the flexible film 1. Although details will be given later, due to the temperature of the flexible film 1 being maintained within a predetermined range, wet-spreading of a functional fluid on the flexible film 1 is suppressed and a conductive pattern having a favorable minute width may be formed.

A drying unit 70 performs a complete drying (complete hardening) process in which a solvent component is completely evaporated by heating the plurality of functional fluids overlaid on each other on the flexible film 1. Once the solvent component is completely evaporated, an inherent electrical performance of the conductive polymer is produced and an electrical performance corresponding to the content ratio of metal nanoparticles is produced.

In addition, when a functional fluid containing metal nanoparticles (Ag nanoparticles) at a content radio of 100% is used, an inherent electrical performance of the metal particles can be produced due to necking occurring only among the metal nanoparticles. It is considered that necking of Ag nanoparticles require that the drying unit 70 performs heating at a processing temperature of 150°C to 220°C for a heating period of one hour or more.

On the other hand, the processing temperature of the drying unit 70 is controlled so as not to exceed a glass-transition temperature of the flexible film 1. For example, when PET is used as a material of the flexible film 1, since PET has a glass-transition temperature of 69°C, when a heating temperature exceeding this temperature is set, heating must be performed instantaneously (for example, a few seconds) to suppress damage to the flexible film 1.

In such a case, a mode in which light irradiation is performed in place of, or in combination with, heating is favorable. For example, rapid thermal annealing (RTA) by visible light using a halogen lamp or the like, infrared irradiation, ultraviolet irradiation, electron beam irradiation, laser irradiation, and the like are effective.

In addition, from the perspective of preventing drying of a nozzle of the ink-jet head 50, a humidity around the ink-jet head 50 is set to 60% or higher or, more favorably, 70% or higher.

A component denoted by reference numeral 11 in FIG. 5 is a processing chamber which can be filled with an inert gas and which is provided with an inert gas fill inlet, an outlet, an inert gas concentration detecting unit, and the like (all not illustrated). The processing chamber 11 integrally houses the ink-jet head 50, the stage 30, and the like and is filled with an inert gas when copper is used as the metal nanoparticles.

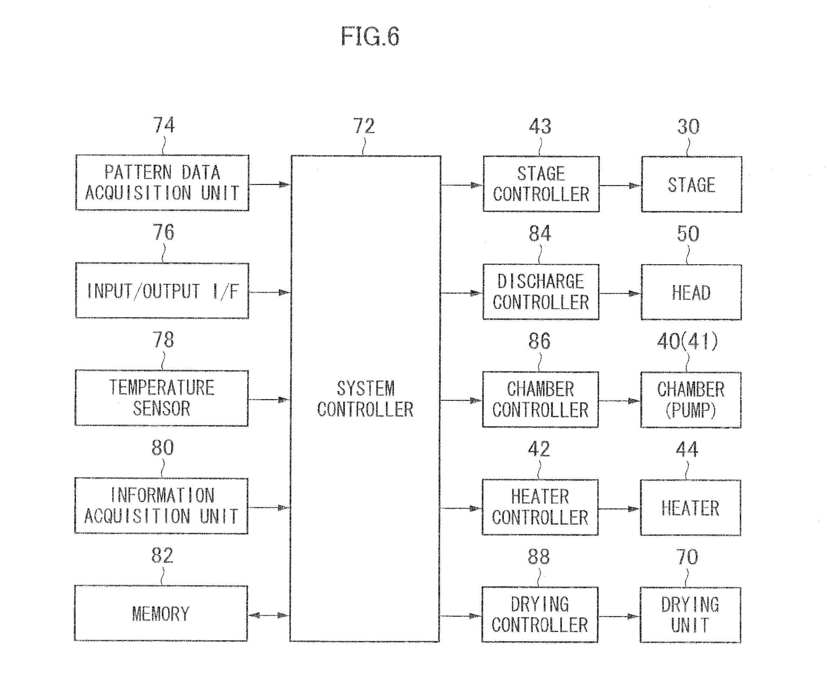

FIG. 6 is a block diagram showing a schematic configuration of a control system of the conductive pattern forming system 10 shown in FIGS. 4 and 5. As shown in FIG. 6, the conductive pattern forming system 10 is configured so that respective components are integrally controlled by a system controller 72.

Upon acquiring various input information (input signals) obtained by a pattern data acquisition unit 74, an input/output interface (input/output I/F) 76, a temperature sensor 78, and an information acquisition unit 80, the system controller 72 generates command signals for respective components of the system which correspond to the input information and sends the command signals to the respective components of the system.

In addition, the system controller 72 functions as a memory controller which controls reading of data from a memory 82 and writing of data to the memory 82. Moreover, the memory 82 shown in FIG. 6 collectively represents a temporary storage unit in which data is temporarily stored, a storage unit which stores data subjected to a predetermined process, a processing area for computation and the like, a parameter storage area which stores control parameters and system parameters, and the like.

When pattern data of a conductive pattern is acquired via the pattern data acquisition unit 74, the pattern data is stored in the memory 82 (primary storage memory) and converted into dot data of a functional fluid by a signal processing unit (not illustrated).

When the dot data is sent to a discharge controller 84, a drive voltage to be applied to the ink-jet head 50 is generated by the discharge controller 84 based on the dot data, and the drive voltage is applied to the ink-jet head 50.

The input/output interface 76 is a device used to input settings of operation modes of the system and various parameters and, at the same time, is a device for outputting data and the like. Specific examples of the input device include a keyboard, a touch panel display device, a mouse, and a joystick. In addition, examples of the output device include an output terminal applicable to a predetermined standard (for example, a USB (Universal Serial Bus) terminal).

The temperature sensor 78 shown in FIG. 6 includes a plurality of temperature sensors which detects temperatures of the various components of the system. For example, the plurality of temperature sensors includes a temperature sensor that detects a temperature of the holding surface 30A (the flexible film 1) of the stage 30 and a temperature sensor that detects an environment temperature of the ink-jet head 50. In addition, although not illustrated, a humidity sensor that detects an environment humidity of the ink-jet head 50 is also provided.

A chamber controller 86 controls operations of the suction chamber 40 (the pump 41) in accordance with a command signal from the system controller 72. For example, when information (thickness information, material information, and the like) regarding the flexible film 1 is acquired from the information acquisition unit 80, the system controller 72 determines a suction pressure based on the information regarding the flexible film 1 and sends a suction pressure command signal to the chamber controller 86. The chamber controller 86 controls the number of rotations of the pump 41 according to the command signal.

The heater controller 42 controls an amount of heating performed by the heater 44 built into the stage 30 according to a command signal from the system controller 72. For example, operations of the heater 44 is controlled according to temperature information regarding the holding surface 30A of the stage 30 acquired by the temperature sensor 78 so that a temperature of the holding surface 30A of the stage 30 falls within a predetermined range.

A drying controller 88 controls operations of the drying unit 70 in accordance with a command signal from the system controller 72. As described earlier, the drying unit 70 has modes of "heating", "light irradiation", and "heating and light irradiation". "Heating", "light irradiation", and "heating and light irradiation" are controlled according to information regarding the flexible film 1 and information regarding the functional fluid which are acquired from the information acquisition unit 80.

(Flow chart of conductive pattern forming method)

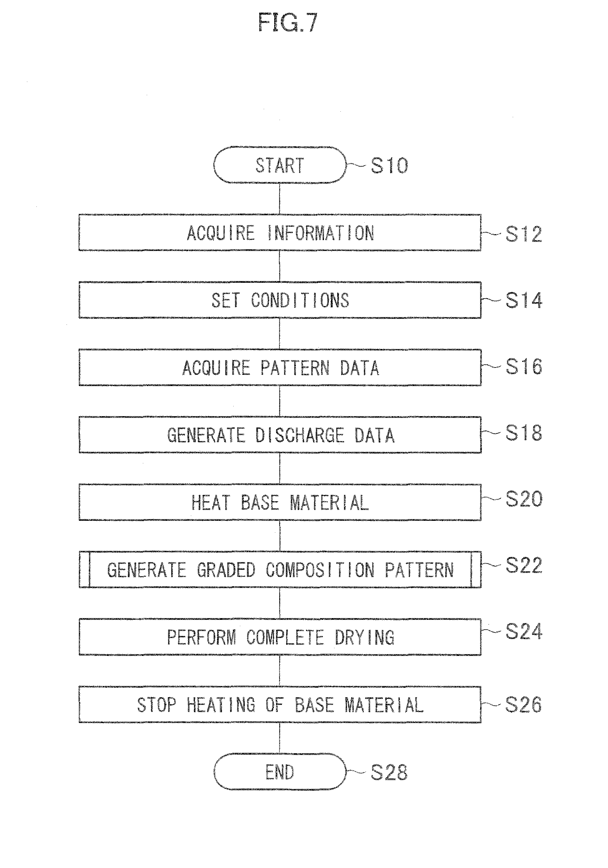

FIG. 7 is a flow chart showing a flow of a conductive pattern forming method according to an embodiment of the present invention. As shown in FIG. 7, when the conductive pattern forming method is started (step S 10), various information such as base material information (information regarding the flexible film 1) and information regarding functional fluids is acquired (step S12), various settings such as the heating temperature of the heater 44 (refer to FIG. 4) are configured based on the various information (step S 14).

Next, as the pattern data acquisition unit 74 (refer to FIG. 6) acquires data regarding a conductive pattern (step S16 in FIG. 7), discharge data (dot data, drive voltage) is generated (step S 18).

Subsequently, heating of the base material (the flexible film 1) is started (step S20), and when the base material reaches a predetermined temperature, a graded composition pattern (conductive pattern) forming step is executed (step S22). Details of the graded composition pattern forming step will be provided later.

After a conductive pattern having a graded composition is formed on the base material in the graded composition pattern forming step (step S22), the flow proceeds to step S24 and a complete drying (complete hardening) step is executed. When a conductive performance of a conductive polymer is realized and metal nanoparticles are crystallized in the complete drying step (step S24), heating of the base material by the heater 44 is stopped (step S26) and the present conductive pattern formation is terminated (step S28).

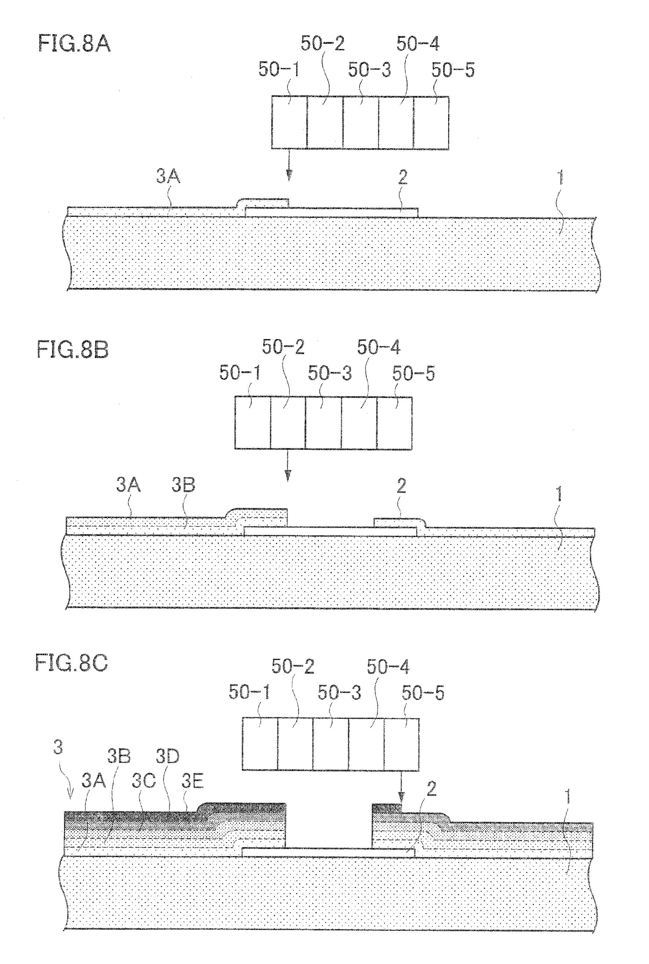

FIGS. 8A to 8C are explanatory diagrams which schematically illustrate the graded composition pattern forming step shown in step S22 in FIG. 7 and which illustrate a mode that uses the first functional fluid 3A to the fifth functional fluid 3E shown in FIG. 3.

FIG. 8A illustrates a state where the first functional fluid 3A is discharged (a discharge direction is indicated by an arrow line) from the ink-jet head 50-1 and a pattern (layer) of the first functional fluid 3A is formed.

Upon formation of the pattern of the first functional fluid 3A, the pattern is in a semi-dried state (semi-hardened state). The semi-dried state is a state in which a solvent component in the first functional fluid 3A is dried so as not to evaporate completely. Specifically, drying is performed by imparting a smaller amount of energy than that applied when drying the solvent component in the first functional fluid 3A so as to evaporate completely (complete drying or complete hardening).

The semi-drying process may be performed using the drying unit 70 shown in FIGS. 5 and 6 or another configuration may be applied. Examples of another configuration include heating by a heater, blowing of heating air or drying air, and the like.

As shown in FIG. 8B, the second functional fluid 3B is discharged from the ink-jet head 50-2 on top of the pattern of the first functional fluid 3A. When a layer of the second functional fluid 3B is formed on the first functional fluid 3A, diffusion occurs in a vicinity of a boundary between the semi-dried first functional fluid 3A and the second functional fluid 3B.

By putting the pattern of the first functional fluid 3A in the semi-dried state, diffusion of a conductive monomer and metal nanoparticles occurs in a vicinity of a boundary between the first functional fluid 3A and the second functional fluid 3B which is overlaid on the pattern of the first functional fluid 3A in a next step and, as a result, a stronger adhesion is obtained between the initially formed pattern and the overlaid pattern.

Meanwhile, the pattern of the first functional fluid 3A and the pattern of the second functional fluid 3B do not entirely constitute a mixed fluid and a composition of the first functional fluid 3A and a composition of the second functional fluid 3B are maintained in portions other than the vicinity of the boundary.

Furthermore, after the second functional fluid 3B is placed in a semi-dried state, the third functional fluid 3C is discharged from the ink-jet head 50-3 on top of the pattern of the second functional fluid 3B. Subsequently, after the third functional fluid 3C is placed in a semi-dried state, the fourth functional fluid 3D is discharged from the ink-jet head 50-4 on top of the pattern of the third functional fluid 3C, and after the fourth functional fluid 3D is placed in a semi-dried state, as shown in FIG. 8C, the fifth functional fluid 3E is discharged from the ink-jet head 50-5 on top of the pattern of the fourth functional fluid 3D.

In this manner, a conductive pattern having a predetermined graded composition is formed by sequentially overlapping the first functional fluid 3A to the fifth functional fluid 3E on top of one another. Subsequently, the flow proceeds to the complete drying step (step S24) shown in FIG. 7 to completely harden the conductive pattern.

As described above, according to the ink-mixing method shown in the present embodiment, since the conductive polymer and the metal nanoparticles are sufficiently diffused and mixed in a stage of a functional fluid that is filled into the ink-jet head 50, a functionally graded material with high accuracy in terms of changes of a functional gradient can be created. In addition, compared to a draw-mixing method which will be described later, since there is no longer a need to devote time to diffuse and mix two types of functional inks, an advantage is gained in that a shorter processing time may suffice.

Moreover, a configuration may be adopted in which, when forming a pattern (layer) of each functional fluid, the base material and the ink-jet heads 50-1 to 50-5 may be relatively moved a plurality of times, an intermittent discharge may be performed in order to discretely arrange dots in one relative movement, and spaces between the discretely-arranged dots may be filled in a next relative movement.

With such a mode, interference among landed droplets of dots (the functional fluid) constituting each layer is prevented and a deformation of a shape of each layer is prevented. In addition, an occurrence of a coffee stain (coffee ring) attributable to a deformation of each layer is also prevented.

While a single layer composing only a conductive polymer and four mixed layers which combine the conductive polymer and metal (silver) nanoparticles have been formed in the present embodiment, the number of layers is not limited to four layers. The number of layers is not particularly limited as long as the respective functional fluids can be laminated so as to produce a gradient of a mixture ratio of the conductive polymer and the metal nanoparticles. Moreover, a same number of ink tanks and ink-jet heads as the number of layers to be formed must be prepared.

In addition, thicknesses of the respective layers need not be uniform as long as a predetermined graded composition is realized. Therefore, a mode can be adopted in which each layer has a different thickness.

[Specific description of graded composition pattern formation]

Next, a functional fluid used in the conductive pattern forming method (system) according to an embodiment of the present invention will be described in detail.

A functional fluid (a first functional fluid) used in the conductive pattern forming method (system) shown in the present example is prepared by dispersing a conductive polymer (PEDOT) in a mixed solvent made up of a low-boiling-point solvent (a solvent with a boiling point as calculated based on mass ratio of 75°C or higher and 105°C or lower) and a high-boiling-point solvent (a solvent with a boiling point as calculated based on mass ratio of 190°C or higher and 290°C or lower).

Specifically, nitromethane (boiling point: 100°C) is used as the low-boiling-point solvent and propylene carbonate (boiling point: 240°C) is used as the high-boiling-point solvent. Other examples of a low-boiling-point solvent include water (boiling point: 100°C), ethanol (boiling point: 78.4°C), isopropyl alcohol (boiling point: 82.4°C), and acetonitrile (boiling point: 82°C).

In addition, other examples of a high-boiling-point solvent include diethylene glycol monoethyl ether (boiling point: 196°C), propylene carbonate (boiling point: 240°C), and glycerol (boiling point: 290°C).

Now, a boiling point at one atmospheric pressure of a mixed solvent in which a plurality of solvents is mixed is obtained by Expression (1) below.

$$T_b = \Sigma(W_i \times T_i) \ldots (1),$$

where $W_i$ = (mass of ith solvent/mass of all solvents) and $T_i$ denotes a boiling point of a single ith solvent.

For example, a boiling point $T_{b12}$ of a mixed solvent of a solvent 1 with a mass with respect to a mass of all solvents of $W_1$ and a single solvent boiling point of $T_1$ and a solvent 2 with a mass with respect to a mass of all solvents of $W_2$ and a single solvent boiling point of $T_2$ is obtained by Expression (2) below.

$$T_{b12} = (W_1 \times T_1) + (W_2 \times T_2) \ldots (2)$$

In addition, a boiling point $T_{b123}$ of a mixed solvent of the solvents 1 and 2 described above and a solvent 3 with a mass with respect to a mass of all solvents of $W_3$ and a single solvent boiling point of $T_3$ is obtained by Expression (3) below.

$$T_{b123} = (W_1 \times T_1) + (W_2 \times T_2) + (W_3 \times T_3) \ldots (3)$$

In other words, a boiling point of a mixed solvent is obtained as a summation of values obtained by multiplying a boiling point value $T_i$ of each solvent by a mass ratio $W_i$ of the solvent among all solvents. Based on a value obtained in this manner, a degree of volatility of a solvent in a functional fluid can be estimated.

In addition, functional fluids (the second to fifth functional fluids) containing metal nanoparticles (Ag nanoparticles) contain acetonitrile (boiling point: 82°C) as a low-boiling-point solvent and diethylene glycol monoethyl ether (boiling point: 196°C) as a high-boiling-point solvent, and further contain cyclohexane (boiling point: 156°C) as a medium-boiling-point solvent.

In this case, the medium-boiling-point solvent is a solvent with a boiling point as calculated based on mass ratio that is higher than 105°C and lower than 190°C. Cyclohexane is a solvent which is favorably used in fluids used in an ink-jet method and is a colorless and transparent solvent having favorable solute solubility.

[Description of conditions for conductive pattern formation]

Next, conditions for conductive pattern formation by a functional fluid will be described in detail.

In order to obtain favorable discharge performance with the ink-jet method, a functional fluid contains a high-boiling-point solvent. Therefore, a nozzle provided on the ink-jet head 50 is prevented from drying due to evaporation of a solvent in the functional fluid during discharge, and occurrences of abnormal discharge (abnormalities in discharge direction and discharge rate) due to an increase in viscosity of the functional fluid in a vicinity of the nozzle or discharge failure due to clogging of the nozzle are avoided.

Next, a temperature condition of the base material (the flexible film 1 shown in FIG. 1), a condition of solvents in the functional fluid, a condition of dot pitch on the base material, and a condition applied when overlaying functional fluids will be described.

With respect to the conditions, a straight-line pattern of a functional fluid (in this case, a polymer fluid not containing metal nanoparticles is used) with one dot-width is formed on the base material, a micrograph of a shape of the pattern is taken, and a presence/absence of jaggies, a presence/absence of bulges, a pattern width, and the like are evaluated based on the micrograph.

A system used in an evaluation experiment is as follows:

Head system: DMP-2831 (manufactured by FUJIFILM Dimatix)
Ink-jet head: DMC-11610
Discharge frequency: 4 kilohertz

Discharge speed: 6 millimeters per second

Preparation of the functional fluid is as follows:

Polymer with molecular weight 20,000 (high molecular weight polymer): 5%
Acetonitrile (low-boiling-point solvent with boiling point of 82°C): 45%
Cyclohexane (medium-boiling-point solvent with boiling point of 156°C): 30.95%
Propylene carbonate (high-boiling-point solvent with boiling point of 240°C): 19%
Surfactant (surface tension modifier): 0.05%

The experiment reveals that while favorable discharge is realized when the molecular weight of the polymer is 20,000, discharge characteristics deteriorate as the molecular weight of the polymer increases, and discharging by the ink-jet method becomes difficult when the molecular weight exceeds 50,000 (for example, a molecular weight of 60,000).

Therefore, from the perspective of discharge performance by the ink-jet method, the molecular weight of the polymer is set to 20,000. In addition, by reducing a mass ratio of the high molecular weight polymer, discharge performance is improved, drying of the nozzle is avoided, and an open time (a period of time from a last discharge timing until drying of the nozzle prevents a normal discharge from being performed) becomes longer.

Since normal discharge may not be performed when the mass ratio of the high molecular weight polymer is set to 10% by mass or higher, the mass ratio of the high molecular weight polymer is set to 5% by mass. As described earlier, although the functional fluid in the experiment does not contain metal microparticles, a similar result can be obtained when using a functional fluid containing both a conductive polymer and metal nanoparticles.

The metal nanoparticles can be dispersed in cyclohexane (boiling point: 156°C) if a dispersant such as laurylamine is used. When the conductive polymer (PEDOT) described above is used as the polymer, by preparing a block copolymer with a polymer such as poly(ethylene glycol), the conductive polymer (PEDOT) can be stably dispersed in a mixed fluid of nitromethane (boiling point: 156°C) and propylene carbonate (boiling point: 240°C).

Cyclohexane (boiling point: 156°C), nitromethane, and propylene carbonate are polar solvents and are all soluble. A functional fluid in which metal nanoparticles and PEDOT are dispersed and which contains a low-boiling-point solvent and a high-boiling-point solvent can be prepared based on the preparation described above.

In other words, a fluid in which both metal nanoparticles and PEDOT are dispersed and which contains a low-boiling-point solvent and a high-boiling-point solvent can be prepared as the functional fluid described above, and it is apparent that a similar result can be obtained when using this functional fluid.

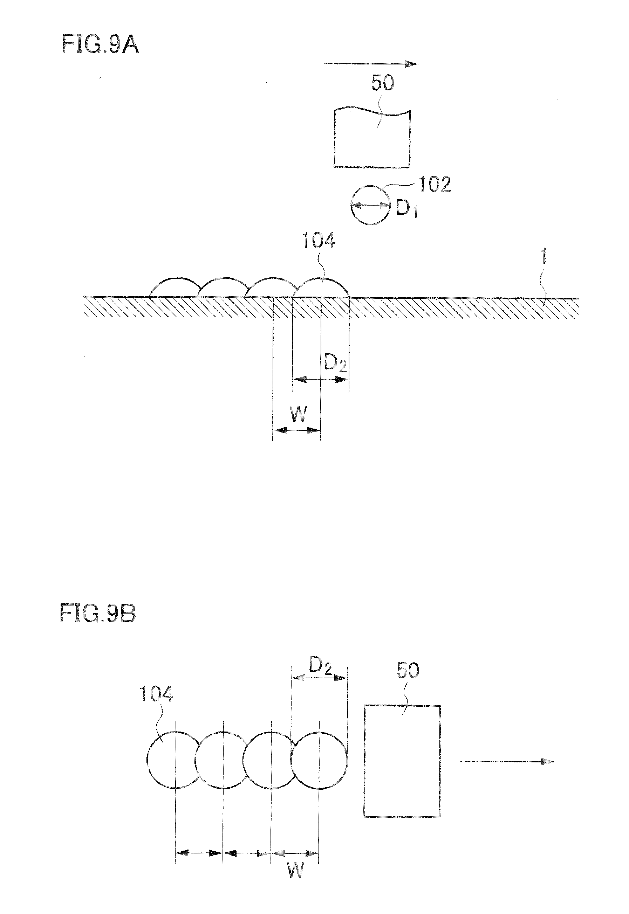

FIGS. 9A and 9B are explanatory diagrams showing a relationship between a diameter $D_1$ of a droplet 102 of a functional fluid discharged from the ink-jet head 50 and a diameter $D_2$ of a dot 104 formed on the flexible film (base material) 1, wherein FIG. 9A is a view from a side surface side of the flexible film 1 and FIG. 9B is a view of the flexible film 1 from a side of the ink-jet head 50.

The diameter $D_1$ of the droplet 102 of the functional fluid shown in FIG. 9A is a value calculated based on a discharge volume on the assumption that the droplet 102 has a spherical shape. When the droplet 102 lands on the flexible film 1, the droplet 102 wet-spreads on the flexible film 1 and the diameter $D_2$ of the dot 104 after its shape stabilizes becomes approximately twice as large as the diameter $D_1$ of the droplet 102 in flight ($D_2 \approx 2 \times D_1$). In addition, a dot pitch W as used herein refers to a center-to-center distance between adjacent dots 104.

(Condition of base material temperature)

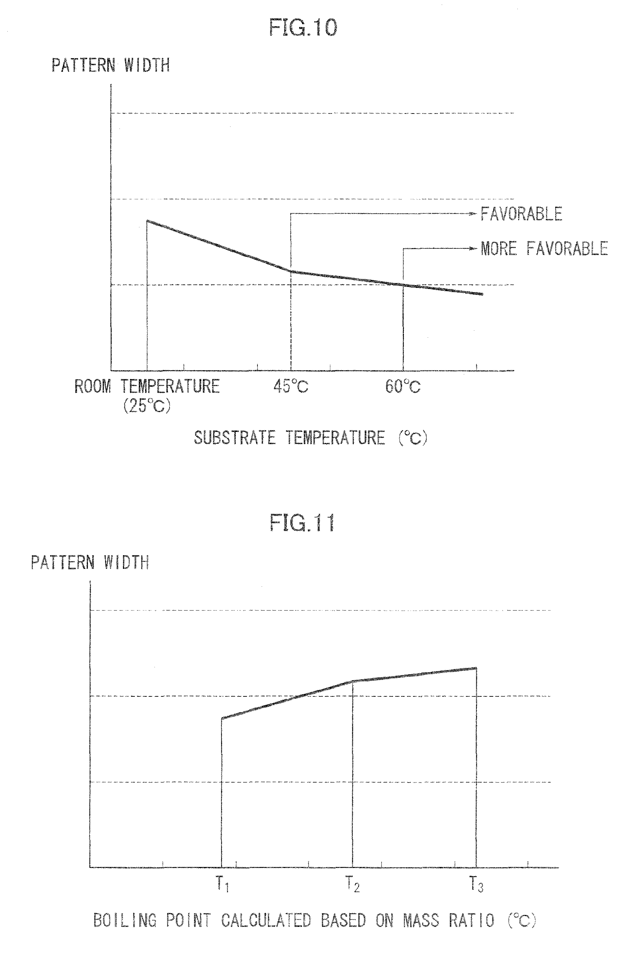

FIG. 10 is a graph showing a relationship between a temperature of the base material (the flexible film 1 shown in FIG. 9) and pattern width. FIG. 10 shows that a pattern width decreases as a temperature of the base material is gradually increased from room temperature (25°C).

In other words, by setting the temperature of the base material to 45°C or higher, fixation of contact lines between the base material and the functional fluid is promoted and the pattern width can be refined. In addition, by setting a surface temperature of the base material to 60°C or higher, the pattern width can be further refined.

(Condition of boiling point of solvent)

FIG. 11 is a graph showing a relationship between a boiling point (volatility: a boiling point calculated according to any one of Expressions (1) to (3) above) as calculated based on mass ratio and a width of a conductive pattern with respect to a mixed solvent in which a plurality of types of solvents with different boiling points is mixed.

Changes are made to the preparation of the functional fluid and to the mass ratio of the high-boiling-point solvent, the medium-boiling-point solvent, and the low-boiling-point solvent of the functional fluid described above and an effect of such changes are considered. Moreover, a temperature of the base material is set to room temperature (25°C).

When the boiling point of the mixed solvent in FIG. 11 is $T_1$°C, a functional fluid is used which contains the high-boiling-point solvent (19% by mass), the medium-boiling-point solvent (30.95% by mass), and the low-boiling-point solvent (45% by mass) at the mass ratio described above.

On the other hand, when the boiling point of the solvent is $T_2$°C (a case where the medium-boiling-point solvent is mixed in place of the high-boiling-point solvent and the low-boiling-point solvent of the mixed solvent with a boiling point of $T_1$°C described above and which the solvent only contains the medium-boiling-point solvent), it is apparent that the pattern width has increased compared to the case where the mixed solvent has a boiling point of $T_1$°C.

In addition, when the boiling point of the solvent is $T_3$°C (a case in which the medium-boiling-point solvent is mixed in place of the low-boiling-point solvent of the mixed solvent with a boiling point of $T_1$°C described above), it is apparent that the pattern width has further increased compared to the case where the mixed solvent has a boiling point of $T_2$°C.

In other words, it is apparent that volatility (a boiling point of the mixed solvent as calculated based on mass ratio) and pattern width are correlated, and that the pattern width decreases significantly due to mixing of the low-boiling-point solvent (when the boiling point of the mixed solvent is further lowered).

This is conceivably because evaporation of a solvent starts from an edge portion in a dot landed on a base material (the flexible film 1 illustrated in FIG. 1), which causes an increase in concentration of a solute component (content) at the edge portion due to evaporation of the low-boiling-point solvent and results in the solute component being fixed to the base material and suppressing spreading of the dot.

(Condition of dot pitch)

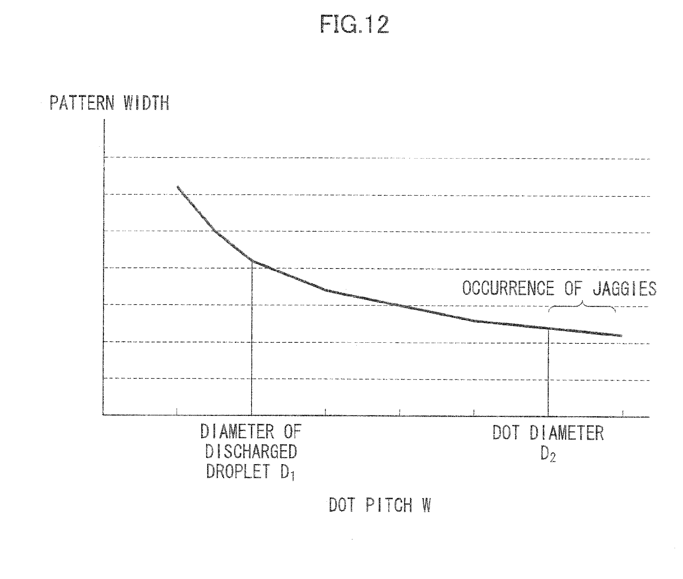

Next, the dot pitch W (refer to FIG. 9) will be described. FIG. 12 is a graph showing a relationship between the dot pitch W and pattern width, and (a) to (g) of FIG. 13 are explanatory diagrams showing planar shapes (micrographs) of patterns.

The temperature of the base material is set to 60°C, and the dot pitch W is quantitatively varied from one half of the discharged droplet diameter $D_1$ until the dot pitch W exceeds the dot diameter $D_2$. Moreover, for example, the discharged droplet diameter $D_1$ may be set to 20 micrometers and the diameter $D_2$ of a dot formed on the base material may be set to 60 micrometers.

As shown in FIG. 12, it is apparent that the pattern width decreases when the dot pitch W increases. On the other hand, it is understood that jaggies occur in a condition expressed as "dot pitch W ≈ dot diameter $D_2$" in which a pattern shown in (f) of FIG. 13 is formed.

In addition, it is understood that an interrupted pattern (a state in which a pattern is disconnected) occurs in a condition expressed as "dot pitch W > dot diameter $D_2$" in which a pattern shown in (g) of FIG. 13 is formed.

In addition, it is understood that in a condition and in which the dot pitch W is slightly smaller than when expressed as "dot pitch W = dot diameter $D_2$" in which a pattern shown in (e) of FIG. 13 is formed, although there are edge portions of the pattern with reduced thickness, no jaggies occur in the pattern.

On the other hand, when the dot pitch W is narrowed so as to equal or fall below the discharged droplet diameter $D_1$ ($W \leq D_1$), the pattern width becomes wide and non-uniform as shown in (a) of FIG. 13 or becomes wide as shown in FIG. 9B and a favorable minute pattern cannot be realized.

When the dot pitch W is reduced (when a dot density of a pattern is increased), a fluid measure (fluid volume) per unit length of the pattern increases and, as a result, pattern width increases. Therefore, pattern width may be further refined by increasing the dot pitch W and reducing the fluid measure per unit length.

On the other hand, excessively increasing the dot pitch W causes adjacent dots to separate from one another and may cause an interrupted pattern (refer to (g) of FIG. 13). By setting the dot pitch W to a value exceeding the discharged droplet diameter $D_1$ ($W > D_1$), a droplet volume per unit length of the pattern can be suppressed and, at the same time, by setting the dot pitch W to a value lower than the dot diameter $D_2$ even when the value of the dot pitch W exceeds the discharged droplet diameter $D_1$, adjacent dots can be reliably connected to each other.

For example, when a nozzle has a diameter of 21 micrometers, since the discharged droplet diameter $D_1$ is assumed to be around 25 micrometers, the dot pitch W is set to a value exceeding 25 micrometers.

Meanwhile, a non-uniform pattern width is conceivably caused by an occurrence of bulges. The occurrence of bulges becomes prominent when drawing is performed at a higher density. For example, bulges occur at non-uniform intervals when the discharge frequency is 1 kilohertz or higher. Therefore, bulges conceivably occur as a pattern width increases locally from the non-uniform positions due to minute fluctuations in discharge direction and discharge rate and a presence of an irregular minute asperity of the base material.

In other words, a minute pattern having a favorable planar shape may be formed as shown in (c) to (e) of FIG. 13 by selecting an appropriate dot pitch W which is greater than the discharged droplet diameter $D_1$ and smaller than the dot diameter $D_2$ and which, together with the discharged droplet diameter $D_1$ and smaller than the dot diameter $D_2$, satisfies a relationship expressed by Expression (4) below so that adjacent dots overlap each other.

$$D_1 < W < D_2 \ldots (4)$$

In particular, by setting the dot pitch W so as to equal or fall below one half of the dot diameter $D_2$ ($W \leq D_2/2$), an even more favorable minute lamination pattern can be formed.

(Condition of dot (pattern) planarization and overlaying)

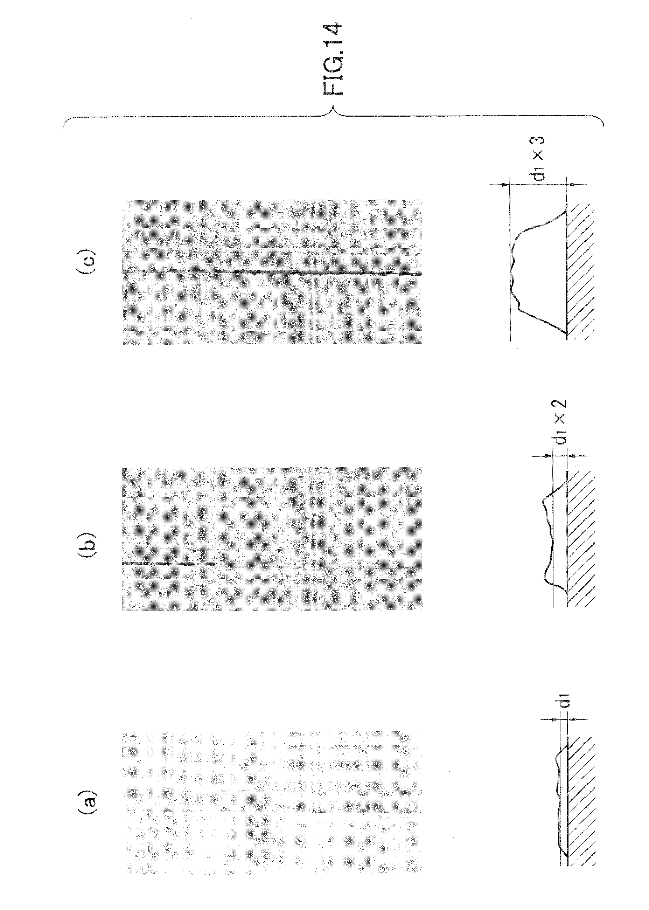

Next, planarization and overlaying of dots (patterns) will be described. Planar shapes shown in upper halves of (a) to (c) of FIG. 14 are micrograph images, and three-dimensional shapes shown in lower halves are schematic illustrations of images taken by a shape measuring microscope.

(a) of FIG. 14 is a diagram showing a planar shape of a pattern of a functional fluid that has not been overlaid (a single-layer functional fluid). The functional fluid is a mixture of 45% by mass of a low-boiling-point solvent, 30.95% by mass of a medium-boiling-point solvent, and 19% by mass of a high-boiling-point solvent, and a base material (the flexible film 1 illustrated in FIG. 1) is heated so as to maintain a surface temperature of 60°C.

Although the pattern of the functional fluid illustrated in (a) of FIG. 14 achieves miniaturization, a film thickness ($d_1$) for obtaining a predetermined impedance (resistance) as a minute electric wiring is insufficient.

(b) of FIG. 14 illustrates a pattern in a case where a functional fluid having the solvent mixture ratio described above is overlaid on the pattern of the functional fluid illustrated in (a) of FIG. 14 which has not been overlaid. As shown in (b) of FIG. 14, a minute width of the pattern is more or less maintained while a film thickness is approximately doubled ($d_1 \times 2$).

(c) of FIG. 14 illustrates a pattern in a case where a functional fluid having the solvent mixture ratio described above is overlaid three times on the pattern of the functional fluid illustrated in (a) of FIG. 14 which has not been overlaid. As shown in (c) of FIG. 14, the width of the pattern is more or less maintained, and although a film thickness is not exactly a value obtained by multiplying the film thickness in the case where no overlaying is performed by the number of overlays, the film thickness is approximately three times the film thickness of the single layer ($d_1 \times 3$).

In other words, by overlaying a functional fluid having the solvent mixture ratio described above a plurality of times and accumulating film thicknesses, a conductive pattern having a desired film thickness may be formed. Moreover, with the conductive pattern forming method shown in the present example, while content ratios of the conductive polymer and the metal nanoparticles of the overlaid functional fluids differ from each other, by applying the solvent mixture ratio described above, a predetermined thickness can be obtained by overlaying functional fluids.

In order to accumulate thickness by overlaying patterns of functional fluids, drying of dots (solvent evaporation) must be optimized and at least a pattern (dots) initially formed on the base material must be planarized to a certain degree.

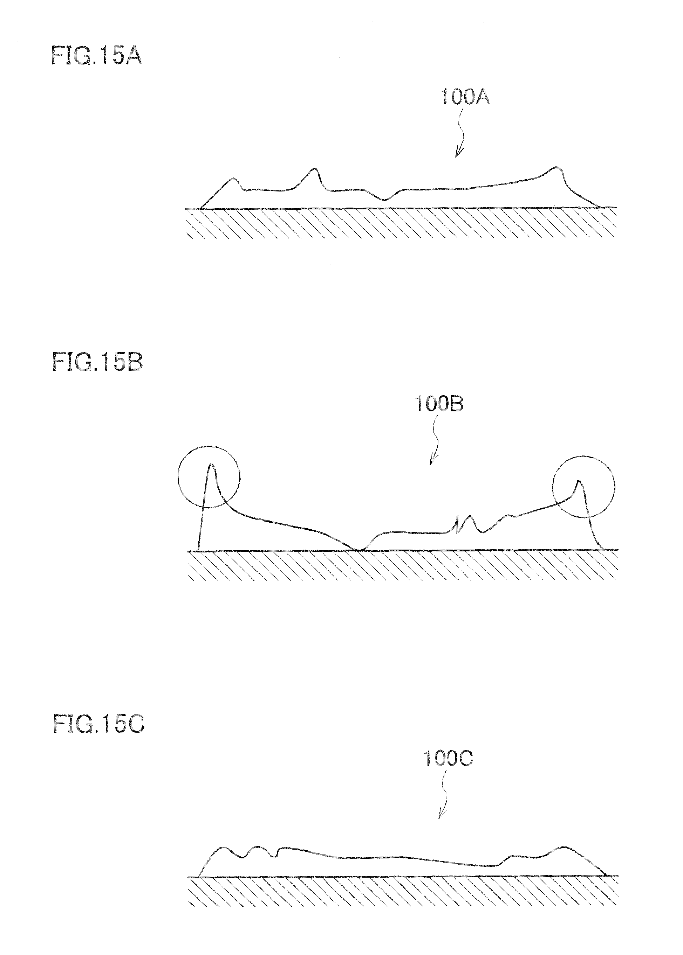

FIGS. 15A to 15C are explanatory diagrams showing an effect of volatility of a mixed solvent on a surface shape of a dot (pattern). FIG. 15A represents a three-dimensional shape of a dot when using a functional fluid that includes a mixed solvent containing the low-boiling-point solvent described above at 45% by mass, the medium-boiling-point solvent at 30.95% by mass, and the high-boiling-point solvent at 19% by mass (the mixed solvent having a boiling point of $T_1$°C shown in FIG. 11). Extreme irregularities have not occurred with a dot 100A shown in FIG. 15A.

FIG. 15B represents a three-dimensional shape of a dot due to a functional fluid that uses a solvent in which the medium-boiling-point solvent is added in place of the high-boiling-point solvent and the low-boiling-point solvent of the mixed solvent with a boiling point of $T_1$°C (only the medium-boiling-point solvent with a boiling point of $T_2$°C shown in FIG. 11 is used). Extreme irregularities (encircled portions) have occurred at edge portions of a dot 100B. In other words, a so-called coffee stain phenomenon has occurred.

FIG. 15C represents a three-dimensional shape of a dot due to a functional fluid that uses a mixed solvent containing 19% by mass of the high-boiling-point solvent and 75.95% by mass of the medium-boiling-point solvent (the mixed solvent with a boiling point of $T_3$°C shown in FIG. 10). Extreme irregularities have not occurred with a dot 100C shown in FIG. 15C in a similar manner to the dot 100A shown in FIG. 15A.

Evaporation of a solvent with a dot on a base material starts from a boundary between the base material, the dot, and a gas. The evaporation of the solvent causes a convection from a center of the dot to an edge portion of the dot. A polymer component is carried by the convention and causes localization of the polymer component at edge portions of the dot. After drying, the edge portions of the dot acquire convex shapes.

Meanwhile, due to the functional fluid containing a high-boiling-point solvent, a rate of evaporation from the boundary between the base material, the dot, and the gas (air) decreases, the convection from the center of the dot to edge portions of the dot also decreases, and planarization of the dot is performed after drying.

(Lamination condition of functional fluids)

(a) to (e) of FIG. 16 are explanatory diagrams showing a planar shape of a pattern of laminated functional fluids.
(a) of FIG. 16 is a pattern shape in a case where the dot pitch W is set approximately the same as the discharged droplet diameter $D_1$ ($W \approx D_1$) and in which a laminated functional fluid (dot) may protrude outside a width of the pattern and a bulge that is a localized increase in pattern width may occur.
(b) to (d) of FIG. 16 are cases where the dot pitch W is set longer than the discharged droplet diameter $D_1$ and shorter than the dot diameter $D_2$ ($D_1 < W < D_2$) and in which a favorable minute laminated pattern is formed. In particular, as shown in (b) of FIG. 16, an even more favorable minute laminated pattern may be formed when the dot pitch W equals one half of the dot diameter $D_2$ ($W = D_2/2$).

Moreover, even in a case where a favorable minute pattern may be formed, when the dot pitch W is further widened as shown in (d) of FIG. 16, a portion with reduced thickness may occur at an edge of the pattern of the laminated functional fluids.

(e) of FIG. 16 is a case where the dot pitch W is set approximately the same as the dot diameter $D_2$ ($W \approx D_2$) in which jaggies occur in a similar manner to (f) of FIG. 13.

In other words, when a pattern is formed by laminating patterns of functional fluids, a favorably laminated pattern is formed when a relationship among the discharged droplet diameter $D_1$, the dot diameter $D_2$, and the dot pitch W satisfies Expression (4) above.
In addition, by setting the dot pitch W so as to equal or fall below one half of the dot diameter $D_2$ ($W \leq D_2/2$), a more favorable minute laminated pattern may be formed.
Furthermore, when a laminated pattern is formed without heating the base material, due to characteristics of a fluid forming a lower layer and characteristics of a fluid forming an upper layer being the same, the fluid is more likely to wet-spread and forming the laminated pattern becomes difficult. Therefore, by heating the base material and maintaining a surface temperature of the base material at 60°C (a temperature more than twice as high as room temperature (25°C)), wet-spreading of the fluid can be suppressed and lamination can be performed while maintaining a minute pattern width.
In addition, by having the functional fluid contain a low-boiling-point solvent, an effect of suppressing wet-spreading can be enhanced.
In summary of the above, by having a functional fluid contain a high-boiling-point solvent, drying of a fluid inside a nozzle due to evaporation of a solvent component of the functional fluid during discharge can be prevented, an abnormal discharge due to an increase in viscosity of the fluid inside the nozzle or a discharge failure due to clogging of the nozzle can be avoided, and a favorable discharge state according to an ink-jet method can be obtained.
In addition, by having the functional fluid contain a high-boiling-point solvent, when overlaying the functional fluid a plurality of times to form a pattern having a predetermined film thickness, drying of dots is optimized and a surface shape of the dots (pattern) becomes favorable (more planarized) and, as a result, an occurrence of a so-called coffee stain phenomenon is suppressed.
Furthermore, by having the functional fluid contain a low-boiling-point solvent, drying of a solvent in a droplet on the base material is promoted, wet-spreading of the droplet is suppressed, widening of a pattern width is suppressed and, as a result, pattern miniaturization can be performed.
In addition, by heating the base material to set a surface temperature of the base material to 60°C during formation of a pattern of a functional fluid, wet-spreading of the functional fluid can be prevented and pattern miniaturization can be performed.
Furthermore, a pattern with a favorable film thickness is formed when a relationship among the discharged droplet diameter $D_1$, the dot diameter $D_2$, and the dot pitch W in the laminated functional fluids satisfies Expression (4) above. Moreover, from the perspective of minute pattern formation, around two to four overlays are favorably performed.
While a discharge condition of a laminated pattern has been clearly specified as described above in the present example, the discharge condition above can be adopted as a discharge condition of an initially formed pattern. In addition, a discharge condition of an initially formed pattern and a discharge condition of a laminated pattern can be set the same.
Moreover, since a laminated functional fluid lands on a pattern of an initially-formed functional fluid, a diameter $D_2$ of a dot of the laminated functional fluid may differ from a diameter $D_2$ of a dot that constitutes the initially-formed pattern due to a difference in wettability between the base material (the flexible film 1 and the organic TF2) and the functional fluid (conductive polymer). Therefore, wettability of the laminated functional fluid on the base material is considered.

While a so-called serial ink-jet head has been exemplified in the present example, a full line ink-jet head can used instead or pattern formation can be performed according to a single-pass method using a full line ink-jet head.

[Second embodiment]

Next, a conductive pattern forming method (system) according to a second embodiment of the present invention will be described.

(Description of conductive pattern forming system (device))

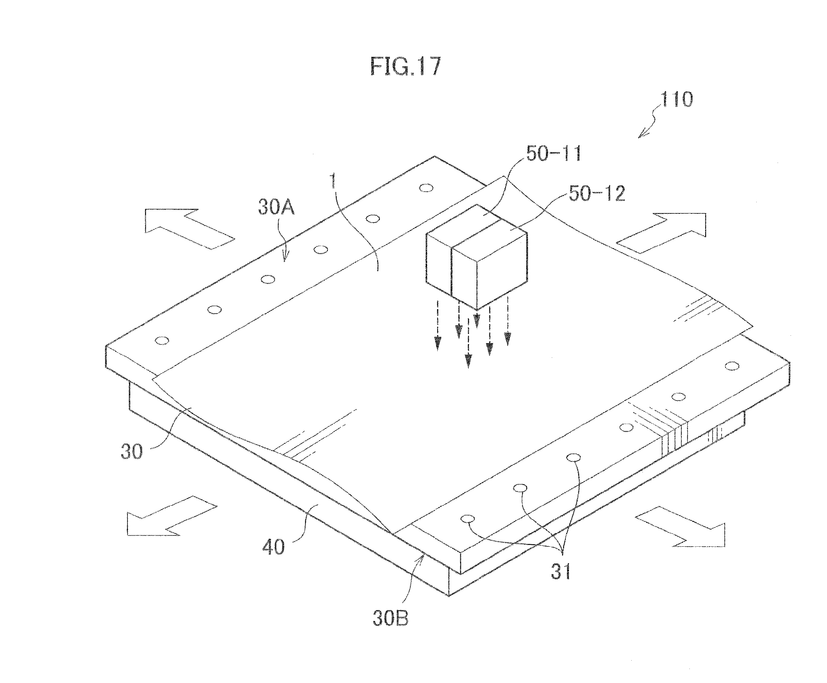

FIG. 17 is a general configuration diagram of a conductive pattern forming system according to the second embodiment of the present invention. Moreover, in FIG. 17, portions that are same as or similar to those in FIG. 4 are denoted by same reference numerals and descriptions thereof will be omitted.

A pattern forming system 110 shown in FIG. 17 includes an ink-jet head 50-11 that discharges a functional fluid containing a conductive polymer (a conductive polymer fluid) and an ink-jet head 50-12 that discharges a functional fluid containing metal nanoparticles (a metal nanoparticle fluid) in place of the ink-jet heads 50-1, 50-2, 50-3, 50-4, and 50-5 which discharge functional fluids of the conductive pattern forming system 10 illustrated in FIG. 4.

A draw-mixing method is applied to the pattern forming system 110 shown in FIG. 17. The draw-mixing method involves discharging a conductive polymer fluid from the ink-jet head 50-11 and discharging a metal nanoparticle fluid from the ink-jet head 50-12, mixing the conductive polymer fluid and the metal nanoparticle fluid on a flexible film 1, and forming a pattern of a mixed fluid containing the conductive polymer fluid and the metal nanoparticle fluid.

After the pattern of the mixed fluid is semi-dried, mixed fluids including the conductive polymer fluid discharged from the ink-jet head 50-11 and the metal nanoparticle fluid discharged from the ink-jet head 50-12 are laminated while varying a mixture ratio of the conductive polymer fluid and the metal nanoparticle fluid, and by performing complete hardening, a conductive pattern is formed which has a graded composition in that a content ratio of the conductive polymer decreases while a content ratio of the metal nanoparticles increases in a thickness direction of the pattern from the flexible film 1.

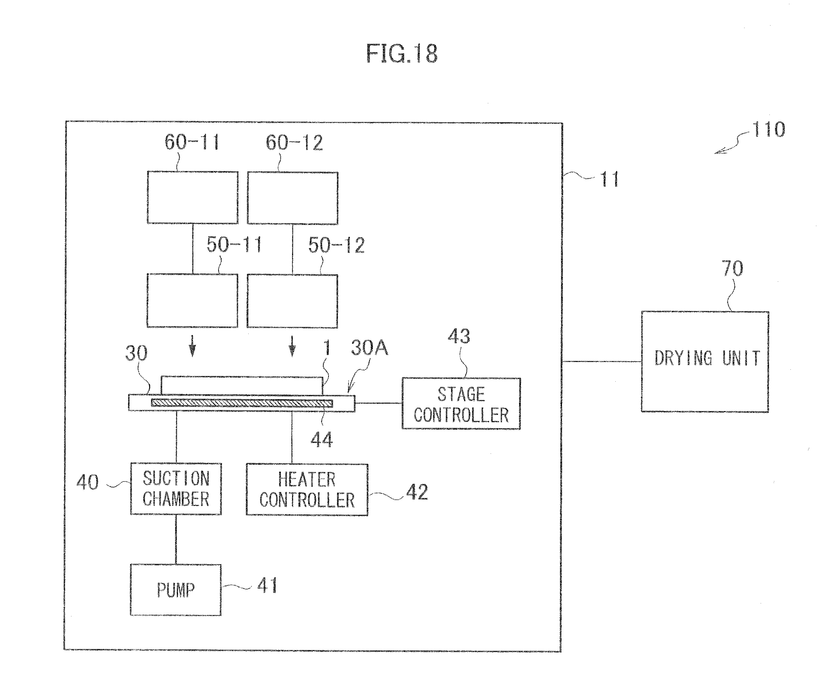

FIG. 18 is a block diagram of the pattern forming system 110 shown in FIG. 17. Moreover, in FIG. 18, portions that are same as or similar to those in FIG. 5 are denoted by same reference numerals and descriptions thereof will be omitted. As shown n FIG. 18, the pattern forming system 110 according to the second embodiment includes a conductive polymer fluid tank 60-11 which accommodates the conductive polymer fluid and a metal nanoparticle fluid tank 60-12 which accommodates the metal nanoparticle fluid in place of the functional fluid tanks 60-1, 60-2, 60-3, 60-4, and 60-5 of the conductive pattern forming system 10 shown in FIG. 5.

As shown in FIG. 18, the conductive polymer fluid tank 60-11 is communicated with the ink-jet head 50-11 via a predetermined fluid flow channel and the conductive polymer fluid is supplied from the conductive polymer fluid tank 60-11 to the ink-jet head 50-11. In addition, the metal nanoparticle fluid tank 60-12 is communicated with the ink-jet head 50-12 via a predetermined fluid flow channel and the metal nanoparticle fluid is supplied from the metal nanoparticle fluid tank 60-12 to the ink-jet head 50-12.

(Description of conductive pattern forming method)

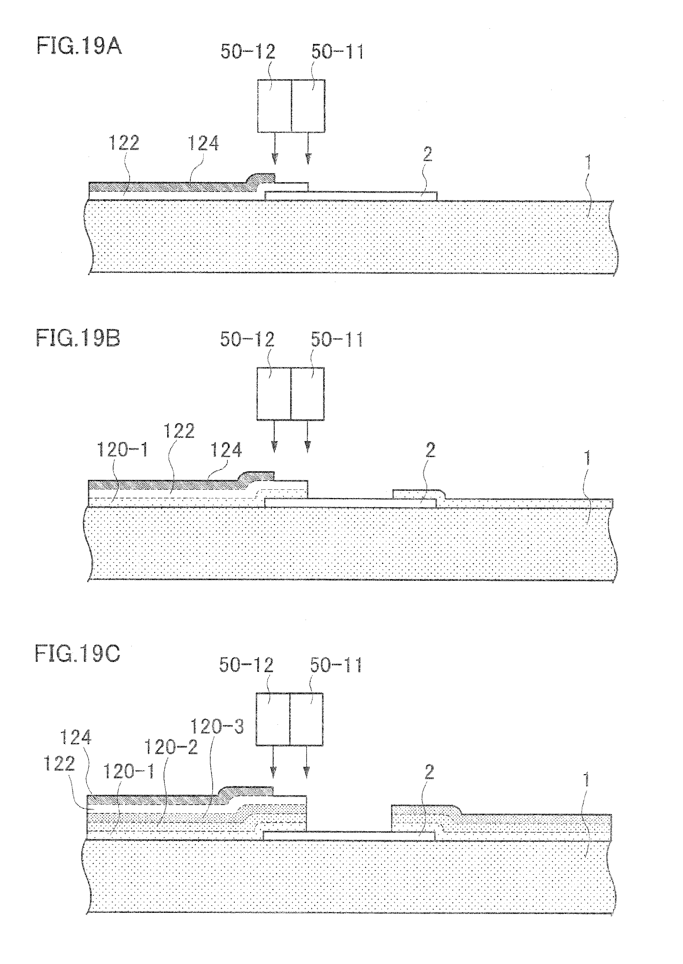

FIGS. 19A to 19C are explanatory diagrams which show a flow of a conductive pattern forming method according to a draw-mixing method and which illustrate a mode where a source wiring 3 and a drain wiring 4 (refer to FIG. 1) of an organic TFT 2 on the flexible film 1 are formed.

First, a heater 44 shown in FIG. 18 is operated to perform heating so that a temperature of the flexible film 1 falls within a predetermined range (40°C to 70°C).

Next, a mixed layer 120-1 containing the conductive polymer fluid and the metal nanoparticle fluid at a mixture ratio of 80:20 is formed on a base material (the flexible film 1 and the organic TFT 2). It is obvious that the mixed layer 120-1 may be a pattern (layer) solely containing the conductive polymer fluid. The mixed layer 120-1 is formed by discharging the conductive polymer fluid on the organic TFT 2 (the flexible film 1) from the ink-jet head 50-11 and discharging the metal nanoparticle fluid on the organic TFT 2 (the flexible film 1) from the ink-jet head 50-12 while moving the base material (from right to left in the diagram).

In FIG. 19A, a layer of the conductive polymer fluid is shown, denoted by reference numeral 122, and a layer of the metal nanoparticle fluid is shown, denoted by reference numeral 124. In this case, a discharge rate (discharged volume) of the conductive polymer fluid and a discharge rate (discharged volume) of the metal nanoparticle fluid are adjusted to a predetermined ratio (volume ratio, 80:20).

Moreover, the adjustment of the ratio of the discharge rate of the conductive polymer fluid and the discharge rate of the metal nanoparticle fluid may be performed by adjusting a drawing dot pitch (dot density). For example, the ratio can be adjusted by controlling discharge of the ink-jet head 50-11 and the ink-jet head 50-12 so that the number of nozzles from which the conductive polymer fluid is discharged and the number of nozzles from which the metal nanoparticle fluid is discharged have a ratio of 80:20 while keeping a discharge rate of each nozzle of the ink-jet head 50-11 and the ink-jet head 50-12 constant.

There may be cases where a desired pattern cannot be formed due to excessive wet-spreading of the conductive polymer fluid discharged from the ink-jet head 50-11 and the metal nanofluid discharged from the ink-jet head 50-12 or cases where an appropriate layer cannot be formed due to an excessive reduction in film thickness at a center of a film due to a coffee stain effect.

While such phenomena can be reduced by heating a base material as is the case in the present embodiment, an appropriate layer may be formed by not discharging the conductive polymer fluid onto an entire surface in a single movement of the base material but instead setting an interval between landed dots in a single movement of the base material so as to be greater than a predetermined dot interval (droplet grid interval) and forming a single layer by discharging in a split manner (intermittent discharge) so as to fill in spaces between dots that have already been formed by a plurality of movements of a stage 30.

A heating temperature of the heater 44 must be adjusted depending on how easily a functional fluid (solvent component) evaporates. Depending on solvent type, pattern formation may be performed by setting a temperature of a base material to a temperature lower than 70°C described earlier such as 50°C.

In addition, the two ink-jet heads 50-11 and 50-12 are arranged as close as possible to each other in order to prevent insufficient diffusion and mixing of the conductive polymer fluid and the metal nanoparticle fluid within the mixed fluid layer due to drying of only one of the conductive polymer fluid and the metal nanoparticle fluid.

Moreover, when the conductive polymer fluid and the metal nanoparticle fluid are simultaneously discharged, droplets of the conductive polymer fluid discharged from the ink-jet head 50-11 and droplets of the metal nanoparticle fluid discharged from the ink-jet head 50-12 may be arranged so as to collide and mix with each other in midair prior to landing.

In addition, in order to promote diffusion and mixing of the mixed fluid, the flexible film 1 that is a base material may be ultrasonically processed by controlling the stage 30 (refer to FIG. 17). In this case, the ultrasonic process is favorably performed by sweeping ultrasonic frequencies or varying a position of the flexible film 1 so as to suppress occurrences of ultrasonic nodes.

The mixed layer 120-1 formed as described above is dried (semi-dried/semi-hardened) to a degree where a solvent component in the mixed fluid is not completely evaporated. A specific method of semi-drying is the same as in the ink-mixing method described earlier.

By placing the mixed layer 120-1 in a semi-dried state, diffusion of particles occurs at a boundary with a mixed layer 120-2 (refer to FIG. 19C) that is laminated on the mixed layer 120-1 and stronger adhesion between the layers can be produced.

Next, on top of the semi-dried mixed layer 120-1, the conductive polymer fluid is discharged from the ink-jet head 50-11 and the metal nanoparticle fluid is discharged from the ink-jet head 50-12 to form the mixed layer 120-2 (refer to FIG. 19C) that includes the conductive polymer fluid and the metal nanoparticle fluid.

The formation of the mixed layer 120-2 is performed by discharging the conductive polymer fluid from the ink-jet head 50-11 and, at the same time, discharging the metal nanoparticle fluid from the ink-jet head 50-12 while moving the base material.

In this case, discharge rates of the ink-jet head 50-11 and the ink-jet head 50-12 are adjusted so that the conductive polymer fluid has a discharge rate of 60% and the metal nanoparticle fluid has a discharge rate of 40%.

The mixed layer 120-2 is formed due to the diffusion and mixing of the conductive polymer fluid and the metal nanoparticle fluid. Since the mixed layer 120-1 is in a semi-dried state, a solvent in the conductive polymer fluid and a solvent in the metal nanoparticle fluid which constitute the mixed layer 120-2 formed on top of the mixed layer 120-1 is received by the mixed layer 120-1 and do not wet-spread excessively.

By placing the mixed layer 120-2 formed as described above in a semi-dried state similar to the mixed layer 120-1, a state is obtained where the mixed layer 120-2 containing the conductive polymer and metal nanoparticles at a quantitative ratio of 60:40 is laminated with a gap between the mixed layers 120-1 and 120-2.

Next, a mixed layer 120-3 is formed on top of the mixed layer 120-2. The formation of the mixed layer 120-3 is similarly performed by simultaneously discharging the conductive polymer fluid and the metal nanoparticle fluid from the ink-jet head 50-11 and the ink-jet head 50-12 while moving the base material. In this case, the conductive polymer fluid and the metal nanoparticle fluid are discharged at a mixture ratio of 40:60.

Since the mixed layer 120-2 is also in a semi-dried state, a solvent of the mixed layer 120-3 formed on top of the mixed layer 120-2 is received by the mixed layer 120-2. By diffusing and mixing the conductive polymer fluid and the metal nanoparticle fluid after discharging the same, the mixed layer 120-3 is laminated.

Furthermore, the mixed layer 120-3 is also semi-dried. A state is obtained where the mixed layer 120-3 containing the conductive polymer and metal nanoparticles at a quantitative ratio of 40:60 is laminated with a gap between the mixed layers 120-2 and 120-3.

As shown in FIG. 19C, the conductive polymer fluid and the metal nanoparticle fluid are simultaneously discharged on top of the semi-dried mixed layer 120-3 from the ink-jet head 50-11 and the ink-jet head 50-12 while moving the base material. In this case, the conductive polymer fluid and the metal nanoparticle fluid are discharged at a mixture ratio of 20:80.

In this manner, respective mixed layers are formed by incrementally (so as to be graded) varying a ratio of discharge rates of the conductive polymer fluid and the metal nanoparticle fluid. Moreover, a 100% metal nanoparticle fluid layer may be finally formed.

After formation of all layers is completed, sintering is performed by a drying unit 70 at around 220°C in a nitrogen atmosphere. Accordingly, conductivity of the conductive polymer in each layer is realized and the metal nanoparticles are crystallized, diffusion of each layer is promoted, and the incrementally-formed layers become continuous. As a result, a conductive pattern is formed which has a graded composition in that a content ratio of the conductive polymer decreases while a content ratio of the metal nanoparticles increases in a thickness direction of the pattern from the base material.

In this manner, forming an upper layer while placing a lower layer in a semi-dried state enables diffusion to proceed to a certain degree between the upper and lower layers. At this point, a state is avoided where an interface between the upper and lower layers disappears or, in other words, a state is avoided where the upper and lower layers are completely diffused and mixed and no distinction can be made between the upper and lower layers.

Moreover, by forming a dummy pattern in an area of the flexible film 1 where the pattern is not formed after forming the respective layers and measuring a height of the dummy pattern with an optical displacement sensor using a laser or the like, since film thickness increases in a state where drying has not progressed and a solvent still remains, a state of dryness can be detected based on the height of the dummy pattern.

While a mode of forming a mixed fluid layer containing one type of conductive polymer fluid and one type of metal nanofluid has been exemplified in the present example, a mode of forming a mixed fluid layer containing one type of conductive polymer fluid and a plurality of types of metal nanofluids, a mode of forming a mixed fluid layer containing a plurality of types of conductive polymer fluids and one type of metal nanofluid, or a mode of forming a mixed fluid layer containing a plurality of types of conductive polymer fluids and a plurality of types of metal nanofluids can alternatively be adopted.

In addition, a conductive pattern having a graded composition can be formed by forming at least three layers. The three layers may include a layer composed solely of a conductive polymer fluid or a layer composed solely of a metal nanoparticles.

(Description of discharge control of mixed fluid)

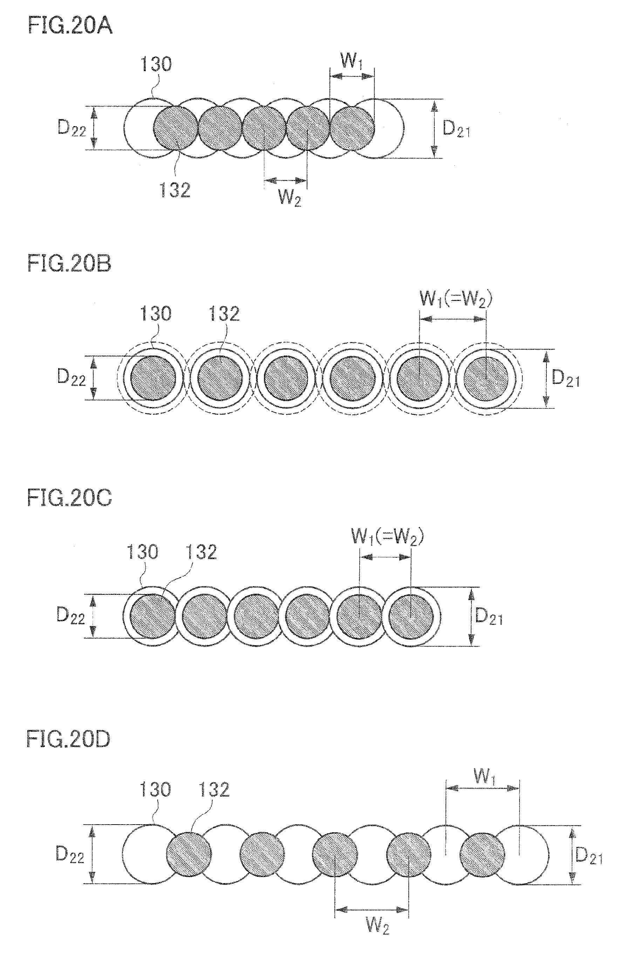

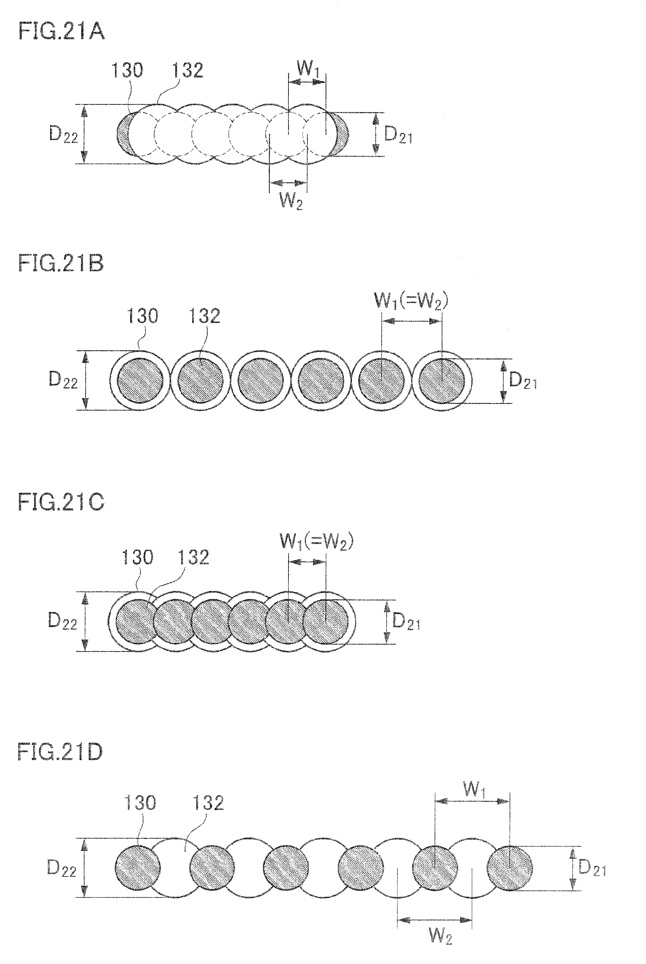

Next, discharge control of the ink-jet head 50 according to the draw-mixing method will be described in detail. FIGS. 20 and 21 are explanatory diagrams of discharge control of the ink-jet head 50 according to the draw-mixing method. In the draw-mixing method shown in the present example, a discharge rate of the ink-jet head 50-11 and a discharge rate of the ink-jet head 50-12 are set different from each other to vary a mixture ratio of a mixed fluid.

FIGS. 20A to 20D illustrate discharge control in a case where a fluid with a greater discharge rate (a higher mixture ratio) is first discharged (first landed on a base material) and a fluid with a smaller discharge rate (a lower mixture ratio) is subsequently discharged (subsequently landed on the base material).

Let us assume that $D_{11}$ denotes a diameter of an airborne droplet that is first discharged, $D_{12}$ denotes a diameter of an airborne droplet that is subsequently discharged, $D_{21}$ denotes a diameter of a dot 130 (illustrated outlined) formed on the base material by the droplet that is first discharged, and $D_{22}$ denotes a diameter of a dot 132 (illustrated blackened) formed on the base material by the droplet that is subsequently discharged. Moreover, diameters of the airborne droplets are values calculated based on discharged volume on an assumption that the airborne droplets have spherical shapes.

FIG. 20A illustrates a case where a dot pitch $W_1$ of the dot 130 is set so as to exceed one half of the diameter $D_{21}$ of the dot 130 and fall under the diameter $D_{21}$ of the dot 130 ($D_{21}/2 < W_1 < D_{21}$) and the dot 132 is formed at a position between (midway between) two adjacent dots 130.

When the dot 130 and the dot 132 are formed as shown in FIG. 20A, a pattern of a mixed fluid having a minute width is conceivably formed and no bulges and jaggies conceivably occur. In addition, mixing of the dot 130 and the dot 132 conceivably occurs in a favorable manner.

FIG. 20B illustrates a case where the dot pitch $W_1$ of the dot 130 is set so as to exceed the diameter $D_{21}$ of the dot 130 ($W_1 > D_{21}$) and the dot 132 is landed at a same position as the dot 130 ($W_1 = W_2$).

In this case, since a droplet forming the dot 130 wet-spreads on the base material, adjacent dots 130 come into contact with each other as indicated by a dashed line.

When the dot 130 and the dot 132 are formed as shown in FIG. 20B, a pattern of a mixed fluid having a minute width is conceivably formed and no bulges conceivably occur. In addition, mixing of the dot 130 and the dot 132 conceivably occurs in a favorable manner. On the other hand, since the dots 130 and the dot 132 are discretely formed, there is a concern that jaggies may occur.

FIG. 20C illustrates a case where the dot pitch $W_1$ of the dot 130 is set so as to exceed one half of the diameter $D_{21}$ of the dot 130 and fall under the diameter $D_{21}$ of the dot 130 ($D_{21}/2 < W_1 < D_{21}$), and the dot 132 is landed at a same position as the dot 130 ($W_1 = W_2$).

When the dot 130 and the dot 132 are formed as shown in FIG. 20C, no jaggies conceivably occur and mixing of the dot 130 and the dot 132 conceivably occurs in a favorable manner. On the other hand, since filling of the fluid forming the dot 130 and the dot 132 is increased, there is a concern that a minute width is not obtained or that bulges may occur.

FIG. 20D illustrates a case where the dot pitch $W_1$ of the dot 130 is set so as to exceed the diameter $D_{21}$ of the dot 130 ($W_1 > D_{21}$) and the dot 132 is formed at a position between (midway between) two adjacent dots 130.

In this case, the dot 132 fills a gap between two adjacent dots 130 to create a state where dots are connected as a whole.

When the dot 130 and the dot 132 are formed as shown in FIG. 20D, a pattern of a mixed fluid having a minute width is conceivably formed and no bulges conceivably occur. On the other hand, since spaces between adjacent dots 130 are filled by the dot 132 that is smaller than the dot 130, there is a concern that jaggies may occur. Insufficient mixing of the dot 130 and the dot 132 is also a concern.

FIGS. 21A to 21D illustrate discharge control in a case where a fluid with a smaller discharge rate (a lower mixture ratio) is first discharged (first landed on a base material) and a fluid with a greater discharge rate (a higher mixture ratio) is subsequently discharged (subsequently landed on the base material). Moreover, in FIG. 21, portions that are same as or similar to those in FIG. 20 are denoted by same reference numerals and descriptions thereof will be omitted.

FIG. 21A illustrates a case where the dot pitch $W_1$ of the dot 130 is set approximately equal to the diameter $D_{21}$ of the dot 130 ($W_1 < D_{21}$ and $W_1 \approx D_{21}$), two adjacent dots 130 are formed so as to slightly overlap each other, and the dot 132 is formed at a position between (midway between) the two adjacent dots 130.

When the dot 130 and the dot 132 are formed as shown in FIG. 21A, a pattern of a mixed fluid having a minute width is conceivably formed and no bulges and jaggies conceivably occur. In addition, mixing of the dot 130 and the dot 132 conceivably occurs in a favorable manner.

FIG. 21B illustrates a case where the dot pitch $W_1$ of the dot 130 is set so as to fall below the diameter $D_{21}$ of the dot 130 ($W_1 < D_{21}$), the dot 132 is landed at a same position as the dot 130, and a dot pitch $W_2$ of the dot 132 is set approximately equal to the diameter $D_{22}$ of the dot 132 ($W_2 = D_{22}$).

When the dot 130 and the dot 132 are formed as shown in FIG. 21B, a pattern of a mixed fluid having a minute width is conceivably formed and no bulges conceivably occur. In addition, mixing of the dot 130 and the dot 132 conceivably occurs in a favorable manner. On the other hand, since the dot 130 is discretely formed, there is a concern that jaggies may occur.

FIG. 21C illustrates a case where the dot pitch $W_1$ of the dot 130 is set so as to exceed one half of the diameter $D_{21}$ of the dot 130 and fall under the diameter $D_{21}$ of the dot 130 ($D_{21}/2 < W_1 < D_{21}$) and the dot 132 is landed at a same position as the dot 130 ($W_1 = W_2$).

When the dot 130 and the dot 132 are formed as shown in FIG. 21C, no jaggies conceivably occur and mixing of the dot 130 and the dot 132 conceivably occurs in a favorable manner. On the other hand, since filling of the fluid forming the dot 130 and the dot 132 is increased, there is a concern that a minute width is not obtained or that bulges may occur.

FIG. 21D illustrates a case where the dot pitch $W_1$ of the dot 130 is set so as to exceed the diameter $D_{21}$ of the dot 130 ($W_1 > D_{21}$), the dot 132 is formed at a position between (midway between) two adjacent dots 130, and the dot pitch $W_2$ of the dot 132 is set so as to exceed the diameter $D_{22}$ of the dot 132 ($W_2 > D_{22}$).

In this case, the dot 132 fills a gap between two adjacent dots 130 to create a state where dots are connected as a whole.

When the dot 130 and the dot 132 are formed as shown in FIG. 21D, a pattern of a mixed fluid having a minute width is conceivably formed and no bulges conceivably occur. On the other hand, since spaces between adjacent dots 130 are filled by the dot 132 that is smaller than the dot 130, there is a concern that jaggies may occur. Insufficient mixing of the dot 130 and the dot 132 is also a concern.

In summary of the above, by forming a dot 130 that is formed by a droplet that is first discharged and forming a dot 132 that is formed by a droplet that is subsequently discharged as shown in FIGS. 20A and 21A, a conductive pattern may be formed which has a minute width, which is free of occurrences of bulges and jaggies, and which has a favorable mixture state of a mixed fluid.

In addition, by forming the dot 130 that is formed by a droplet that is first discharged and forming the dot 132 that is formed by a droplet that is subsequently discharged as shown in FIGS. 20B and 21B , a conductive pattern may be formed which has a minute width, which is free of occurrences of bulges, and which has a favorable mixture state of a mixed fluid.

Furthermore, by forming the dot 130 that is formed by a droplet that is first discharged and forming the dot 132 that is formed by a droplet that is subsequently discharged as shown in FIGS. 20C and 21C, a conductive pattern may be formed which has a minute width, which is free of occurrences of jaggies, and which has a favorable mixture state of a mixed fluid.

The discharge conditions (dot formation conditions) shown in FIGS. 20 and 21 are also applicable to second and subsequent layers of a laminated pattern formed by a plurality of overlays. Moreover, when applying the discharge conditions (dot formation conditions) to the second and subsequent layers of a laminated pattern, consideration may be given to wet-spreading with respect to a fluid that forms a first layer instead of to wet-spreading with respect to the base material. A discharge condition within a same layer, a condition regarding a boiling point of a solvent, a temperature condition of a base material, and a condition regarding diffusion and mixing can be applied to the present embodiment.

[Specific application examples]

Next, application examples of a wiring structure formed using the conductive pattern forming method (system) presented above will be described. FIG. 22 is a sectional perspective view of a touch panel 200 formed using the conductive pattern forming method described above.

For the touch panel 200 shown in FIG. 22, colorless and transparent indium tin oxide (ITO) is used as a material of metal nanoparticles. In other words, the conductive pattern forming method shown in the present example is applied to a transparent electrode film 204 of an upper conductive layer 202 and a transparent electrode film 208 of a lower electrode layer 206.

A member denoted by reference numeral 210 is a front panel and a member denoted by reference numeral 212 is a base substrate. A detailed description of a structure and a description of functions of the touch panel 200 will be omitted.

According to the conductive pattern forming method and the conductive pattern forming system configured as described above, by forming, as a source wiring and a drain wiring of an organic TFT formed on a flexible film, a conductive pattern having a graded composition structure in which a content ratio of a conductive polymer decreases while a content ratio of metal microparticles increases from a base material (the flexible film and the organic TFT) with respect to a thickness direction, a bonding performance with the base material is secured and electrical bonding on the flexible film with the organic TFT is enabled due to flexibility and electrical performance of the conductive polymer, and favorable electrical performance as the source wiring and the drain wiring is secured due to action of the metal microparticles.

In addition, by configuring a functional fluid containing a conductive polymer and metal nanoparticles so as to contain a low-boiling-point solvent having a boiling point that is equal to or higher than 75°C and equal to or lower than 105°C, evaporation of a solvent in a droplet landed on the base material is promoted to suppress spreading of the droplet (dot), and a pattern with a minute width is realized.

Furthermore, by configuring the functional fluid containing a conductive polymer and metal nanoparticles so as to contain a high boiling-point solvent having a boiling point that is equal to or higher than 190°C and equal to or lower than 290°C, drying of a nozzle of an ink-jet head is prevented and an occurrence of an abnormal discharge is prevented. In addition, since drying of the droplet (dot) landed on the base material is optimized, a more favorable planar shape of the dot is obtained and planarization of the dot is achieved.

Moreover, by optimizing a discharged droplet diameter, a dot diameter, and a dot pitch, a favorable conductive pattern having a minute width and free of occurrences of bulges and jaggies may be formed.

Furthermore, a minute pattern may be formed by applying a fluid repellency treatment to an outer side of the minute pattern. Specific examples of a fluid repellency treatment include a mode in which a laser beam is irradiated in an inert gas atmosphere.

While the source wiring 3 and the drain wiring 4 of the organic TFT 2 formed on the flexible film 1 have primarily been exemplified in the present embodiment, the conductive pattern forming method and the conductive pattern forming system are widely applicable to electrical wirings formed on a base material including an electrical wiring between elements such as IC chips formed on a wafer or a printed wiring substrate, an electrical wiring between an element and a connector, and the like.

In addition, the minute pattern can be pieced together in a planar direction of the base material to form a pad (electrode). For example, by forming a plurality of minute patterns with a width of one dot in a consecutive manner in a width direction and forming the plurality of minute patterns so that adjacent minute patterns come into contact with each other, a wide pattern having a width exceeding one dot may be formed.

A pad can also be formed by intermittently forming minute patterns with a one dot width and subsequently forming minute patterns with a one dot width so as to fill spaces (gaps) between the intermittently-formed minute patterns with a one dot width.

In a configuration in which scanning is performed using the head 50 shown in FIG. 4 or 17 in two perpendicular directions (for example, a main scanning direction and a vertical scanning direction), a formation direction of a minute pattern with a one dot width may be set as the main scanning direction and a plurality of minute patterns with a one dot width may be formed in the vertical scanning direction, or a formation direction of a minute pattern with a one dot width may be set as the vertical scanning direction and a plurality of minute patterns with a one dot width may be formed in the main scanning direction.

With the device configurations illustrated in FIGS. 4 and 17, since a dot can be formed at an arbitrary droplet landing position on a base material, an expanded width portion can be formed at a portion (a middle portion, an end portion, or the like) of a minute pattern with a one dot width. Moreover, in a favorable mode, a width of the expanded width portion is set equal to or greater than twice the width of the minute pattern.

[Another embodiment]

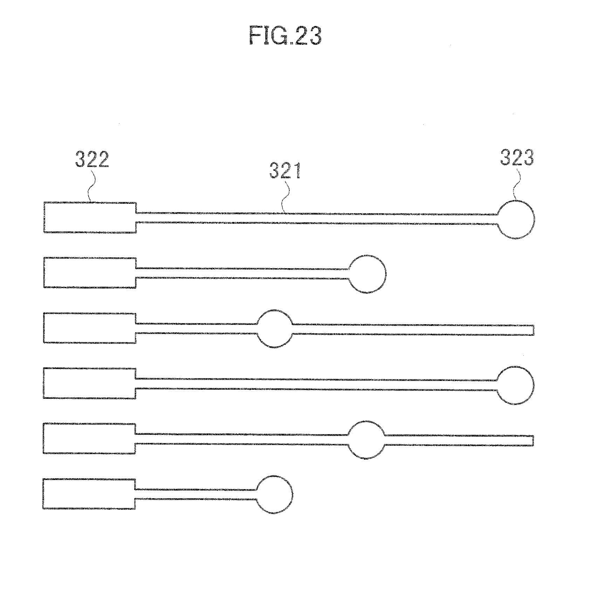

Next, another embodiment of the present invention will be described. FIG. 23 is an enlarged view which shows an enlargement of a portion of a surface of the flexible film 1 (refer to FIG. 1) on which a conductive pattern is formed and which illustrates an electrical wiring 321 (which corresponds to the source wiring 3, the drain wiring 4, and the like shown in FIG. 1) and a pad 322 and a land 323 connected to the electrical wiring 321. Note that the organic TFT 2 (refer to FIG. 2) is not illustrated in FIG. 23.

The pad 322 shown in FIG. 23 is a conductive pattern to which an IC (module) and a bare chip are bonded. The pad 322 has a greater width than the electrical wiring 321 and has a rectangular planar shape. In addition, the land 323 is a conductive pattern that is connected to the electrical wiring 321 and has a circular or a semi-circular planar shape. With a flexible film (substrate) having a multilayered structure, a through hole may be formed on the land 323.

In the present specification, conductive patterns with a greater width than the electrical wiring 321 such as the pad 322 and the land 323 illustrated in FIG. 23 may sometimes be referred to as a "pad" without distinction among the pad 322, the land 323, and the like. In other words, regardless of planar shape and regardless of whether a through hole is formed or not, a conductive pattern with a width greater (a greater surface area per unit length) than an electrical wiring having a minute width will be referred to as a "pad" or an "electrode".

Moreover, a bump to be bonded to the electrical wiring 321 may be formed. A bump is a conductive pattern which electrically connects connected bodies mounted on different substrates and is, for example, a hemispherical or trapezoidal metallic protrusion which is formed on an electrical connection terminal portion and which is used when mounting an IC chip formed on a silicon wafer directly onto a printed wiring substrate. A bump is required to have adhesion with a base material as well as favorable electrical performance.

A metal with high electrical conductivity such as gold (Au), silver (Ag), and copper (Cu) is used for the pad 322 (the land 323). Meanwhile, a predetermined mechanical strength is required for bonding between the base material (the flexible film 1) and the pad 322. Therefore, a favorable bonding strength and electrical bonding are secured by using a conductive polymer for a bonding portion between the base material and the pad 322, and favorable electrical performance is secured by increasing a content ratio of metal nanoparticles in a thickness direction.

In the other embodiment presented below, a mode will be described in which the pad 322 is formed so as to be connected to the electrical wiring 321 (an electrical wiring connected to a source terminal and a drain terminal of an organic TFT 2) formed on the flexible film 1, and the pad 322 has a graded composition in which a content ratio of a conductive polymer decreases and a content ratio of metal nanoparticles increases from the base material (the flexible film 1).

In the following description, the pad 322 in which a composition component ratio of the conductive polymer varies from 100% to 20% and a composition component ratio of the metal nanoparticles (Au microparticles) varies from 0% to 80% is fabricated according to an ink-mixing method or a draw-mixing method. While various thicknesses of the pad 322 are conceivable, in this case, the thickness of the pad 322 is set approximately equal to the electrical wiring 321. Moreover, portions that are same as or similar to those already described are denoted by same reference numerals and descriptions thereof will be omitted.

Since a bottom surface (a base material-side surface) of the pad 322 is constituted by a conductive polymer, a bonding strength of the base material is secured. In addition, a top surface (outermost surface) of the pad 322 is constituted by metal nanoparticles. Moreover, a solder, a conductive adhesive, or the like is used to electrically bond the pad 322 and an IC chip or the like to each other.

(Formation of pad by ink-mixing method)

Configurations shown in FIGS. 4 to 6 can be adopted as a system (device) configuration for forming the pad 322 according to the ink-mixing method. In addition, since the flow chart presented in FIG. 7 and the forming method presented in FIG. 8 can be adopted as a method of forming the pad 322, a detailed description will be omitted here.

Moreover, when a thickness of the pad 322 needs to be greater than that of the electrical wiring 321, respective functional fluids are overlaid during formation of layers (denoted by reference characters 3A to 3E in FIG. 8C) of the respective functional fluids.

(Formation of pad by draw-mixing method)

Configurations shown in FIGS. 6, 17, and 18 can be adopted as a system (device) configuration for forming the pad 322 according to the draw-mixing method. In addition, since the flow chart presented in FIG. 7 and the forming method presented in FIG. 19 can be adopted as a method of forming the pad 322, a detailed description will be omitted here.

Moreover, the two ink-jet heads 50-11 and 50-12 are arranged as close as possible to each other in order to prevent insufficient diffusion and mixing of the conductive polymer fluid and the metal nanofluid within the mixed fluid layer due to drying of only one of the conductive polymer fluid and the metal nanofluid.

In addition, when the conductive polymer fluid and the metal nanofluid are simultaneously discharged, droplets of the conductive polymer fluid discharged from the ink-jet head 50-11 and droplets of the metal nanofluid discharged from the ink-jet head 50-12 may be arranged so as to collide and mix with one other in midair prior to landing.

Furthermore, while details will be described later, favorably, the two ink-jet heads 50-11 and 50-12 are configured so that widths where respective nozzles are provided are set greater than a pattern width of a single pad and so that a single layer is formed by a single movement of the stage 30 (refer to FIG. 17). Accordingly, the metal nanofluid and the conductive polymer fluid more easily mix with each other.

In addition, in order to promote diffusion and mixing of inks, the flexible film 1 (refer to FIG. 17) that is a base material may be ultrasonically processed by controlling the stage 30. In this case, the ultrasonic process is favorably performed by sweeping ultrasonic frequencies or varying a position of the flexible film 1 so as to reduce occurrences of ultrasonic nodes. These techniques can also be applied when forming a minute electrical wiring pattern.

According to the draw-mixing method described above, the pad 322 can be formed using an ink-jet head. In addition, the draw-mixing method is advantageous in that fewer types of functional fluids and fewer ink-jet heads may suffice regardless of the number of layers to be formed. Any number of mixed layers containing a metal nanofluid and a conductive polymer fluid may be laminated as long as such layers are formed so that respective ink mixture ratios are incrementally graded.

(Description of discharge control (dot arrangement))

In pad formation according to the draw-mixing method, a subsequently-discharged fluid may be landed so as to overlap a position where a first-discharged fluid had landed. In particular, when intermittent discharge is performed and dots are separated from each other, by landing a subsequently-discharged fluid at a same position of a first-discharged fluid before the first-discharged fluid dries, diffusion and mixing of the respective fluids are facilitated and a mixed fluid wet-spreads in a favorable manner.

In addition, a mode can be adopted in which mixed fluids (dots) are approximately simultaneously landed by combining intermittent discharge and simultaneous droplet landing using two heads.

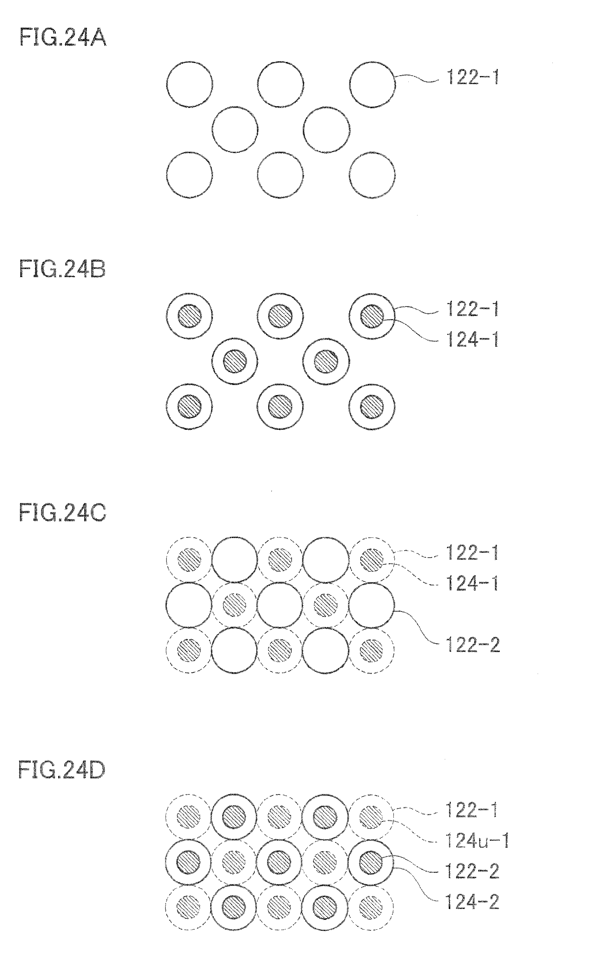

Furthermore, as shown in FIGS. 24A to 24D, a favorable mode for preventing landing interference between dots involves drying discretely-arranged dots (dots in which two types of inks are sufficiently diffused) and then forming dots so as to fill spaces among the discretely-arranged dots.

Specific examples of drying discretely-arranged dots include a mode in which an ink to be applied later is heated in advance. A higher effect can be achieved by arranging two heads so as to be sufficiently close to each other.

For example, when forming the mixed layer 120-2 shown in FIG. 19C, by intermittently discharging a conductive polymer fluid from the ink-jet head 50-11 in a first scanning operation (FIG. 24A), a dot 122-1 of the conductive polymer fluid is discretely formed.

Next, by intermittently discharging a metal nanofluid from the ink-jet head 50-12 in a second scanning operation, as shown in FIG. 24B, a dot 124-1 of the metal nanofluid is formed in an overlapping manner at a same position as the conductive polymer fluid 122-1 formed in the first scanning operation.

Furthermore, by intermittently discharging the conductive polymer fluid from the ink-jet head 50-11 in a third scanning operation, as shown in FIG. 24C, a dot 122-2 of the conductive polymer fluid is formed so as to fill between the dots 122-1 of the conductive polymer fluid which had been formed in the first scanning operation.

Subsequently, by intermittently discharging the metal nanofluid from the ink-jet head 50-12 in a fourth scanning operation, as shown in FIG. 24D, a dot 124-2 of the metal nanofluid is formed in an overlapping manner at a same position as the conductive polymer fluid 122-2 formed in the third scanning operation.

Subsequently, in a similar manner, layers of mixed fluids with different mixture ratios of the conductive polymer fluid and the metal nanofluid can be formed. As shown, by intermittently and discretely arranging the conductive polymer fluid and the metal nanofluid so as to form layers of mixed fluids so that gaps are filled by a plurality of scanning operations, a period of time required for diffusion and mixing can be shortened.

In addition, when drying of one of the two types of fluids proceeds at a high rate, by having the one fluid discharged afterwards, drying of the fluid with the higher drying rate can be prevented from proceeding first and insufficient diffusion and mixing may be prevented.

Furthermore, in a mode where a plurality of types of metal nanofluids is used, a mixed fluid of two types of metal nanofluids may be used. For example, when forming a mixed layer of gold nanoparticles and copper nanoparticles, modes can be adopted which respectively use a gold nanoparticle fluid, a copper nanoparticle fluid, and a mixed fluid layer that is a 50%-50% mixture of a gold nanoparticle fluid and a copper nanoparticle fluid.

(Another mode of discharge control according to draw-mixing method)

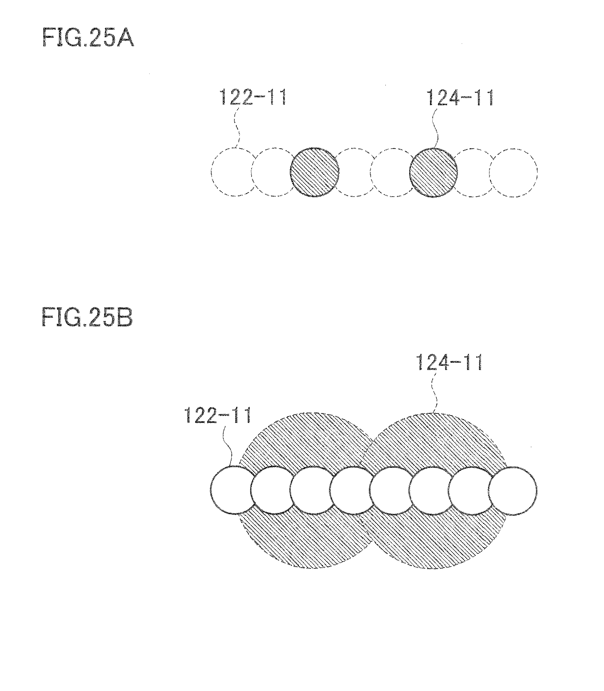

FIGS. 25A and 25B are explanatory diagrams of a mode in which a component with a lower quantitative ratio is first applied and a component with a higher quantitative ratio is subsequently applied according to the draw-mixing method.

In FIG. 25A, a hatched dot 124-11 represents a dot of a metal nanofluid applied first. On the other hand, a dot 122-11 depicted by a dashed line represents a virtual dot of a conductive polymer fluid that is applied after the metal nanofluid has been applied.

The metal nanofluid and the conductive polymer fluid have a quantitative ratio of 2:8 which determines a ratio between the number of dots 124-11 made by the metal nanofluid and the number of dots 122-11 made by the conductive polymer fluid.

Moreover, although not illustrated, the dot 122-11 made by the conductive polymer fluid is also formed at a same droplet landing position as the dot 124-11 made by the metal nanofluid.

FIG. 25 illustrates a state where the conductive polymer fluid is applied after the dot 124-11 made by the first-applied metal nanofluid has wet-spread sufficiently.

In this manner, due to sufficient wet-spreading and sufficient thinning of the dot 124-11 made by the first-applied metal nanofluid, since the dot 122-11 made by the conductive polymer fluid is diffused and mixed in a thickness direction while it wet-spreads, a period of time required for diffusion and mixing of the dot 124-11 made by the metal nanofluid and the dot 122-11 made by the conductive polymer fluid can be reduced.

Favorably, in order to improve wettability of the dot 124-11 made by the first-applied metal nanofluid, the flexible film 1 is subjected to a property modification treatment (lyophilic treatment) or a component that improves wettability is added to the metal nanofluid.

[Application example]

Next, an application example according to the first and second embodiments and the other embodiment presented above will be described.

(Discharge control according to draw-mixing method)

In the draw-mixing method, a conductive polymer fluid and a metal nanofluid may be simultaneously discharged from the ink-jet head 50-11 and the ink-jet head 50-12 to form each layer, or the conductive polymer fluid and the metal nanofluid may be discharged in this order.

In a case where the conductive polymer fluid and the metal nanofluid are sequentially discharged to form a single layer and where there is a difference in discharge rates between the two fluids or, in other words, when a ratio of discharge rates of the two fluids is not 50%-50%, a configuration may be adopted in which a fluid with a higher discharge rate is discharged first.

In particular, in a case where the fluid discharged first dries dramatically (a case where the first-discharged fluid has a property in which drying proceeds more rapidly compared to drying of the subsequently-dried fluid), since the lower the discharge rate, the more rapidly drying proceeds, the fluid with a higher discharge rate is favorably discharged first. Accordingly, diffusion and mixing of the two types of fluids can proceed in a smooth manner.

Furthermore, in this case, the fluid with the lower discharge rate which is to be subsequently discharged may be discharged at an increased dot pitch density using droplets that are smaller than a predetermined size. Accordingly, a period of time required for diffusion and mixing can be reduced.

In this manner, forming an upper layer while placing a lower layer in a semi-dried state enables diffusion to proceed to a certain degree between the upper and lower layers. At this point, a state is avoided where an interface between the upper and lower layers disappears or, in other words, a state is avoided where the upper and lower layers are completely diffused and mixed and no distinction can be made between the upper and lower layers.

(Detection of state of dryness)

After layers (pads) of the respective mixed fluids are formed, a dummy pattern may be laminated in an area where a pattern of the flexible film 1 is not formed and a height of the dummy pattern may be measured with an optical displacement sensor using a laser or the like. Since film thickness increases in a state where drying has not progressed and a solvent still remains, a state of dryness can be detected based on the height of the dummy pattern.

(Semi-drying process)

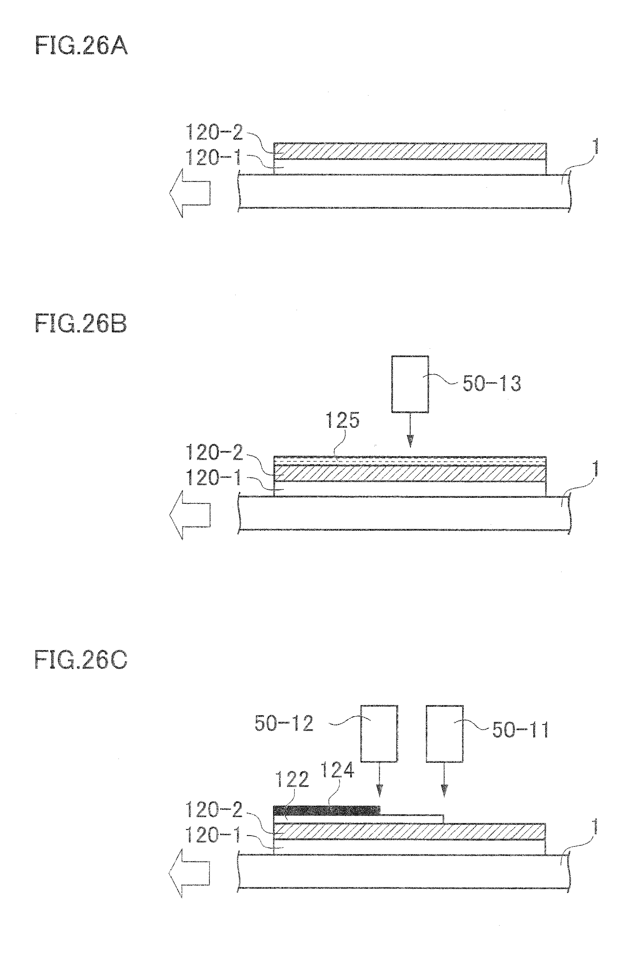

Next, a semi-drying process will be described with reference to FIGS. 26 to 29. While a semi-drying process will be described below using an example of pad formation by a conductive polymer fluid and a metal nanofluid, the semi-drying process can obviously be applied to wirings which use a conductive polymer and metal nanoparticles (such as the source wiring 3 and the drain wiring 4 shown in FIG. 1).

In the present invention, when a fluid is discharged on top of a layer formed below to form an upper layer, it is important that the lower layer is dried (semi-dried) to a degree where a solvent component in a fluid of the lower layer is not completely evaporated.

In a case where a quick-drying fluid is used and drying occurs rapidly after discharge, a chemical treatment that reduces a degree of drying of the lower layer may be applied immediately prior to forming the upper layer. When a mixed layer 120-2 is laminated on a conductive polymer fluid layer 120-1 as shown in FIG. 26A, a chemical 125 is applied to a surface of the mixed layer 120-2 from an ink-jet head 50-13 as shown in FIG. 26B in order to suppress complete hardening of the mixed layer 120-2.

As a result, compared to a case where the chemical 125 is not applied, a next layer may be formed while delaying process of drying of the mixed layer 120-2 and maintaining a favorable semi-dried state. FIG. 26C illustrates a state where a conductive polymer fluid and a Au nanoparticle fluid for forming a next mixed layer are discharged on a surface of the mixed layer 120-2.

For example, when a solvent of a conductive polymer fluid (a metal nanofluid) is used as the chemical 125, the solvent may be applied in advance to the lower layer or the lower layer may be immersed in the solvent. In addition, a same solvent need not necessarily be used. In case of a water-based ink, water or alcohol may be used, and in case of a solvent ink, a solvent having a similar polarity or molecular weight may be used.

Furthermore, a chemical treatment that reduces the degree of drying of the lower layer may be applied after forming the upper layer instead of immediately prior to forming the upper layer. Such a treatment is effective since the chemical also penetrates from the upper layer. In addition, a same solvent may be used for the upper and lower layers, or a solvent that dissolves a content of the lower layer may be used on a fluid of the upper layer.

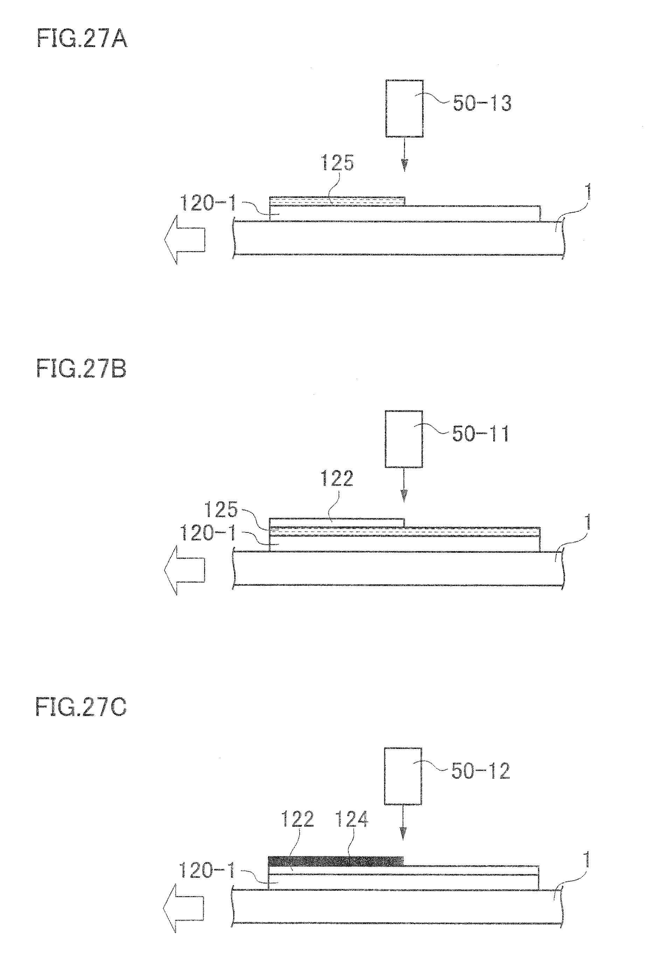

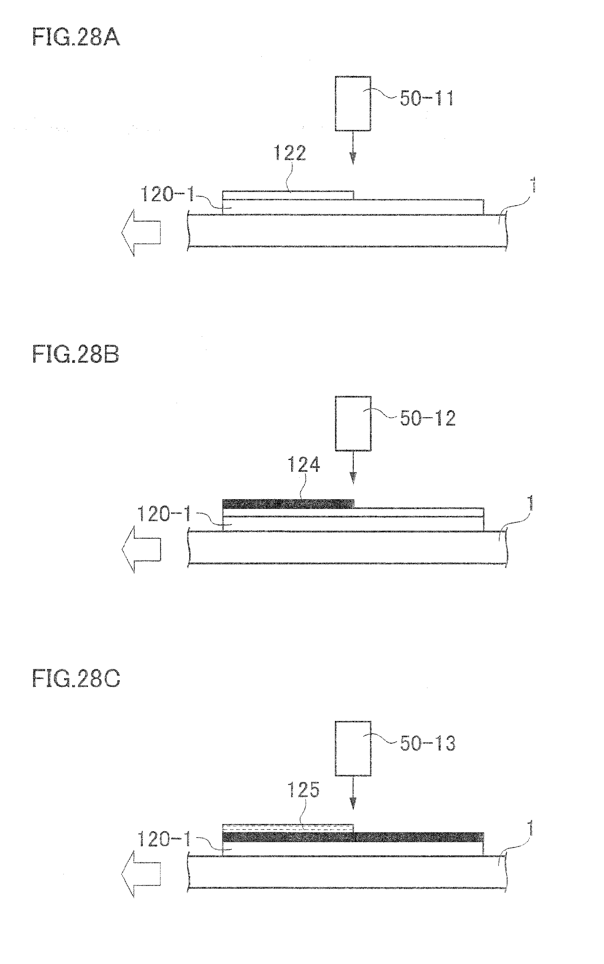

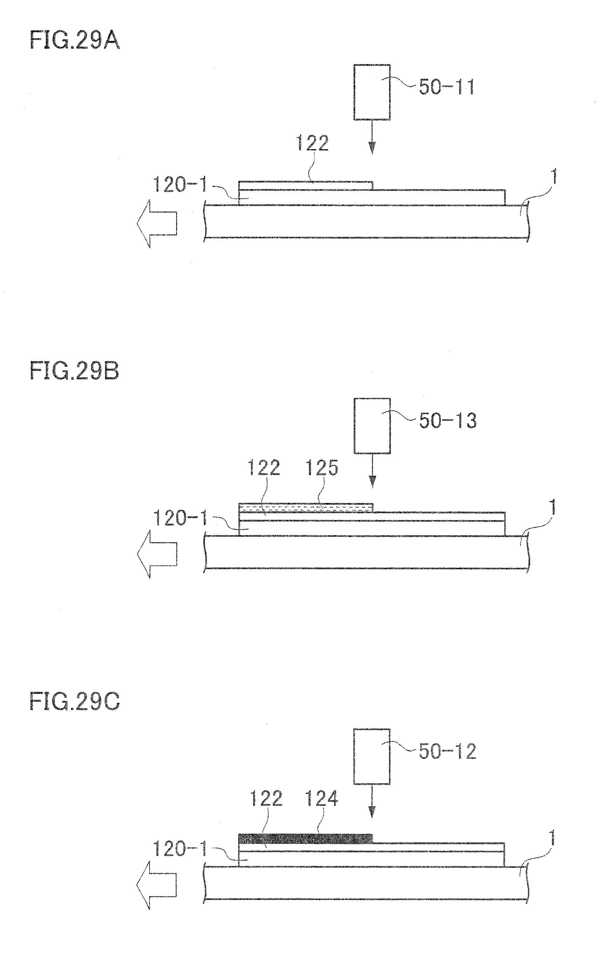

Moreover, the chemical treatment promotes diffusion (intralayer) between a plurality of fluids that constitutes a mixed layer. FIGS. 27 to 29 are explanatory diagrams schematically showing chemical treatments according to modes. FIGS. 27A to 27C illustrate a mode in which a chemical is applied before formation of a mixed layer, FIGS. 28A to 28C illustrate a mode in which a chemical is applied after formation of a mixed layer, and FIGS. 29A to 29C illustrate a mode in which a chemical is applied during formation of a mixed layer.

FIG. 27A is a state where the chemical 125 is applied from the ink-jet head 50-13 to the surface of the conductive polymer fluid layer 120-1. FIG. 27B is a state where a conductive polymer fluid is applied from the ink-jet head 50-11 after the chemical 125 has been applied to the surface of the conductive polymer fluid layer 120-1, and FIG. 27C is a state where a metal nanofluid is applied from the ink-jet head 50-12 after the conductive polymer fluid has been applied.

In the state illustrated in FIG. 27C, the chemical is received at a vicinity of the surface of the conductive polymer fluid layer 120-1.

By applying the chemical 125 prior to formation of a mixed layer by a conductive polymer fluid and a metal nanofluid in this manner, drying of the conductive polymer fluid and the metal nanofluid can be suppressed and, at the same time, diffusion of a conductive polymer and metal nanoparticles can be promoted within the mixed layer.

In addition, progress of drying of the lower layer (the conductive polymer fluid layer 120-1) is slowed down, and since interlayer diffusion also occurs at a vicinity of a boundary between the lower layer and the mixed layer (the upper layer), adhesion between the lower layer and the upper layer is strengthened.

FIG. 28A is a state where a conductive polymer fluid (layer) 122 is applied from the ink-jet head 50-11 to the surface of the conductive polymer fluid layer 120-1, and FIG. 28B is a state where the metal nanofluid 124 is applied from the ink-jet head 50-12 on the conductive polymer fluid 122.

FIG. 28C is a state where the chemical 125 is applied from the ink-jet head 50-13 after the conductive polymer fluid (layer) 122 and the metal nanofluid (layer) 124 which form a mixed layer have been applied. By applying the chemical 125 after applying the conductive polymer fluid and the metal nanofluid which constitute a mixed layer in this manner, diffusion of the conductive polymer and the metal nanoparticles within the mixed layer can be promoted while suppressing drying of the conductive polymer fluid and the metal nanofluid (or while dissolving the conductive polymer fluid and the metal nanofluid with the chemical 125 even if drying of the conductive polymer fluid and the metal nanofluid progresses).

In addition, progress of drying of the mixed layer (a lower layer in formation of a next mixed layer) is slowed down to maintain a favorable semi-dried state, and due to interlayer diffusion that occurs at a vicinity of a boundary between the mixed layer and an upper layer that is next formed, adhesion between the mixed layer and the next-formed upper layer is strengthened.

FIG. 29A is a state where the conductive polymer fluid (layer) 122 is applied from the ink-jet head 50-11 to a surface of the conductive polymer fluid layer 120-1. FIG. 29B is a state where the chemical 125 is applied from the ink-jet head 50-13 on top of the conductive polymer fluid layer 122, and FIG. 29C is a state where the metal nanofluid (layer) 124 is applied from the ink-jet head 50-12 on top of the conductive polymer fluid (layer) 122 to which the chemical 125 has been applied.

By applying the chemical 125 during formation of a mixed layer in this manner, diffusion of Cu nanoparticles and Au nanoparticles within the mixed layer can be promoted while suppressing drying of the conductive polymer fluid layer 122 and the metal nanofluid layer 124.

An ink-jet head is favorably used when applying the chemical 125 as described above, since there is an advantage in that a simplified configuration may be adopted because the chemical 125 can be applied within a same device and a smaller dosage of the chemical may suffice due to fluid-saving characteristics of an ink jet.

In addition, a degree of dryness of a solvent may be measured after or during formation of a lower layer to be fed back to formation of an upper layer. For example, a roughness or reflection intensity of a layer is measured by a laser or the like and is used as an indication of dryness.

A degree of dryness may be measured by coming in to contact with a region that is not used as a functional material or a dummy region that is separately provided for measurement purposes. In addition, by bringing an absorbent fiber or paper into contact with a film, a degree of dryness may be determined based on a degree of absorption of a solvent ink. A timing of discharge of a next layer is decided based on a determination of the degree of dryness to perform further hardening of a lower layer.

In a case of a UV monomer ink that hardens when irradiated by ultraviolet rays or the like, irradiation may be performed at an exposure that is lower than an exposure necessary for complete hardening in order to promote diffusion of upper and lower layers. In addition, hardening of the UV monomer ink may be realized by exposing an entire layer after layer formation or hardening may be performed immediately after landing of a droplet using a compact UV exposure source such as a UV-LED that can be used to perform a scanning operation at the same time as a scanning operation with a head or a stage.

Since a UV monomer ink has a characteristic in which a solvent is less likely to evaporate even when heated, when using a monomer ink, intralayer diffusion and interlayer diffusion can be promoted due to heating.

Moreover, a method of exposing immediately after landing of a droplet is suitable for forming an intricate pattern. Even when using a UV monomer ink, a degree of dryness or a degree of hardening may be measured in a similar manner to the case of a solvent described above.

When using a monomer ink such as a UV monomer ink, a mode in which a degree of hardening is measured using fluorescence may also be adopted.

Moreover, the semi-drying process can also be applied to formation of a conductive pattern using the ink-mixing method. The ink-jet head 50-13 that discharges a chemical may be added to the system configuration illustrated in FIG. 4 and a chemical applying step may be added before, after, or both before and after formation of respective layers (patterns) constituting a graded composition.

(Fluid repellency treatment frame)

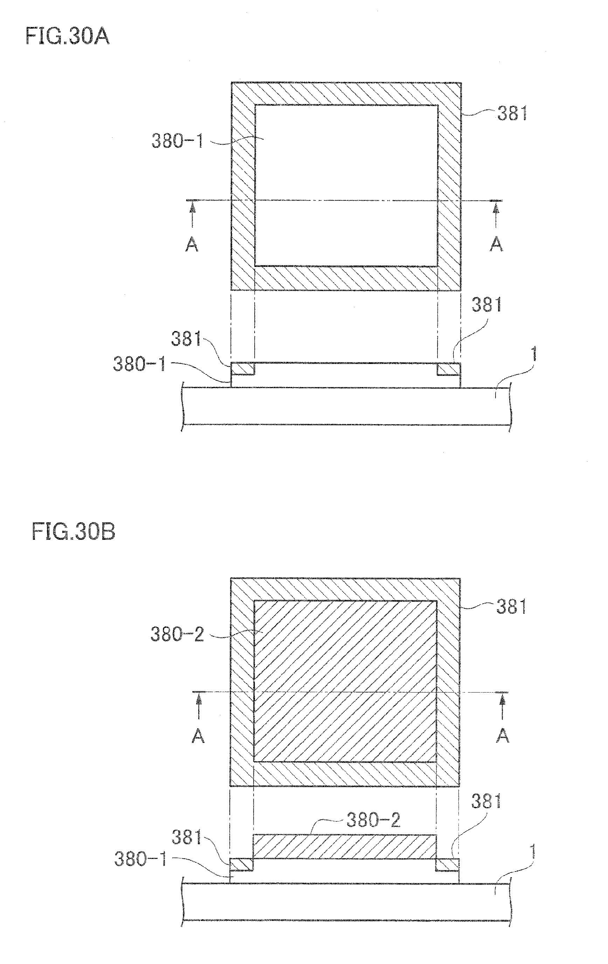

Next, a fluid repellency treatment frame will be described with reference to FIG. 30.

When a fluid of an upper layer drops off of or protrudes over an edge portion of a lower layer after the upper layer has been formed, a height of the layer may become non-uniform and a defect may occur as a functional material. In order to prevent such a phenomenon, after forming the lower layer, an edge portion of the lower layer may be imparted with fluid repellency to a fluid of an upper layer to be formed next.

FIG. 30A is an top view and a sectional view taken along a dashed line A-A when a functional fluid layer 380-1 is formed directly on the flexible film 1 and a fluid repellency treatment portion 381 is subsequently formed in an edge portion of the functional fluid layer 380-1. In addition, FIG. 30B is an top view and a sectional view taken along a dashed line A-A when a functional fluid layer 380-2 is subsequently formed on top of the functional fluid layer 380-1.

As shown in FIG. 30B, due to the fluid repellency treatment portion 381 formed in the edge portion of the functional fluid layer 380-1, a fluid that forms the functional fluid layer 380-2 discharged on a surface of the functional fluid layer 380-1 is prevented from protruding to an outside of the fluid repellency treatment portion 381. Therefore, the functional fluid layer 380-2 can be appropriately formed in an upper layer of the functional fluid layer 380-1.

Various printing techniques can be utilized to form the fluid repellency treatment portion 381 including patterning using a photomask, direct laser imaging, laser scanning, patterning using an ink jet, and screen printing.

By imparting fluid repellency to an edge portion of a pattern (layer) in this manner, a graded functional material with high precision can be formed.

(Edge frame)

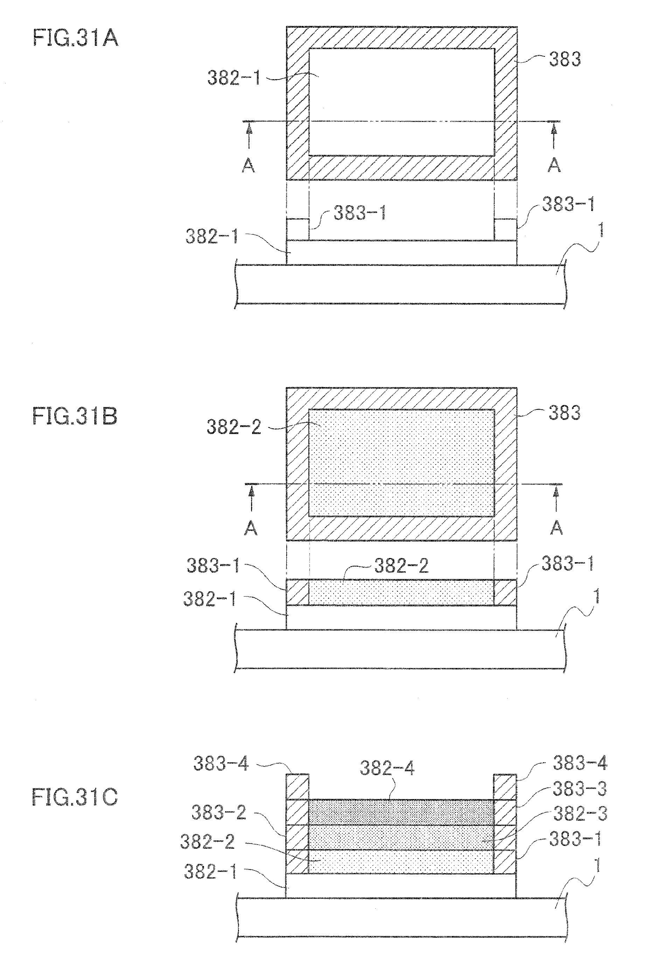

Next, an edge frame will be described with reference to FIG. 31.

A treatment involving providing an edge portion with a convex frame may be performed in place of a fluid repellency treatment in order to prevent fluid of an upper layer from dropping off of or protruding over an edge portion of a lower layer.

FIG. 31A is an top view and a sectional view taken along a dashed line A-A when a functional fluid layer 382-1 is formed directly on the flexible film 1 and an edge frame 383-1 is subsequently formed in an edge portion of the functional fluid layer 382-1.

Various printing techniques can be utilized to generate the edge frame 383-1 including patterning using an ink jet and screen printing. When performing patterning using an ink jet, an effective method involves forming a pattern using a UV monomer ink and exposing the pattern immediately afterwards in order to harden and generate the edge frame 383-1.

In this case, a "monomer ink" refers to an ink containing a functional monomer (polymerizable compound) as a main component, and may also contain a surfactant, a polymerization initiator, a polymerization inhibitor, a solvent other than a monomer, and the like. Furthermore, a pigment and microparticles such as metal nanoparticles and ceramic particles may be dispersed, or a functional polymer or the like may be dissolved in the monomer ink.

FIG. 31B is a top view and a sectional view taken along a dashed line A-A when a functional fluid layer 382-2 is formed on top of the functional fluid layer 382-1 shown in FIG. 31A.

As shown in FIG. 31B, due to the edge frame 383-1 formed in the edge portion of the functional fluid layer 382-1, a fluid that forms the functional fluid layer 382-2 discharged on a surface of the functional fluid layer 382-1 is prevented from protruding to an outside of the edge frame 383-1. Therefore, the functional fluid layer 382-2 can be appropriately formed in an upper layer of the functional fluid layer 382-1.

Furthermore, FIG. 31C is a sectional view showing functional fluid layers 382-3 and 382-4 formed while forming edge frames 383-2 and 383-3 from the state shown in FIG. 31B, and further forming an edge frame 383-4.

Due to the edge frame 383-4, a functional fluid layer can be further formed on top of the functional fluid layer 382-4 while preventing a fluid from protruding.

By sequentially providing an edge of a pattern (functional fluid layer) with a frame and then forming an upper functional fluid layer, a graded functional material with high precision can be formed even when there are many ink layers or when a pattern is complicated.

(Head length of ink-jet head)

When forming a mixed layer by discharging two types of inks according to the draw-mixing method, favorably, a configuration (elongated head) is adopted in which a total length (head length) of headsets of ink-jet heads is longer than one side of a base material, and each layer is formed by a single pass. In particular, when two types of inks are sequentially discharged as described with reference to FIG. 26, a fluid that is subsequently discharged is favorably formed by a single pass. With a configuration in which a subsequently-discharged fluid is discharged in a split manner by performing a plurality of scanning operations using an ink-jet head, a problem arises in that a lapse of time between a first scanning operation and a second scanning operation increases and a difference in a degree of diffusion occurs. In order to prevent such a phenomenon, discharge is performed by a single pass using an elongated head.

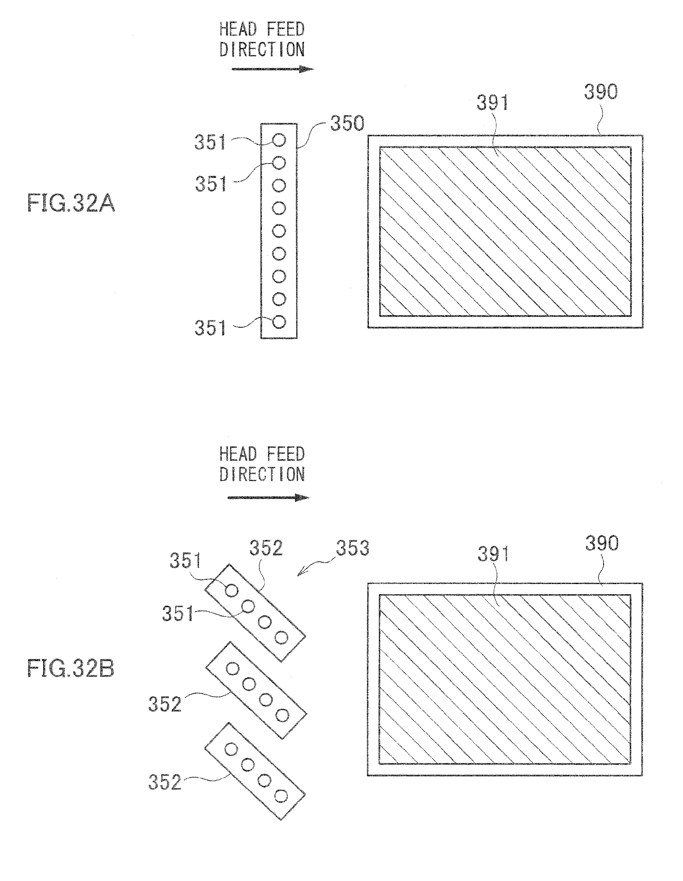

FIG. 32A is a schematic view showing a relationship between a region 391 of a graded functional material formed on a base material 390 (the flexible film 1 shown in FIG. 1) and a width direction of a head 350.

For example, as shown in FIG. 32A, a nozzle 351 of the head 350 is favorably arranged longer than a width of the base material 390. By adopting such a configuration, discharge of an ink from the head 350 to the region 391 can be appropriately performed with a single relative movement of the head 350 and the base material 390 (a single pass). Moreover, the head 350 may be smaller than the width of the base material 390 as long as an arrangement of the nozzle 351 is formed longer than a width of the region 391.

In addition, in a case where it is difficult to configure the head 350 as shown in FIG. 32A due to a large size of the base material 390 or the like, a headset 353 that is long enough to cover the width of the base material 390 may be constructed by combining a plurality of short head modules 352 as shown in FIG. 32B, whereby the headset 353 may be treated as a single head 350.

(Drawing trace measure)

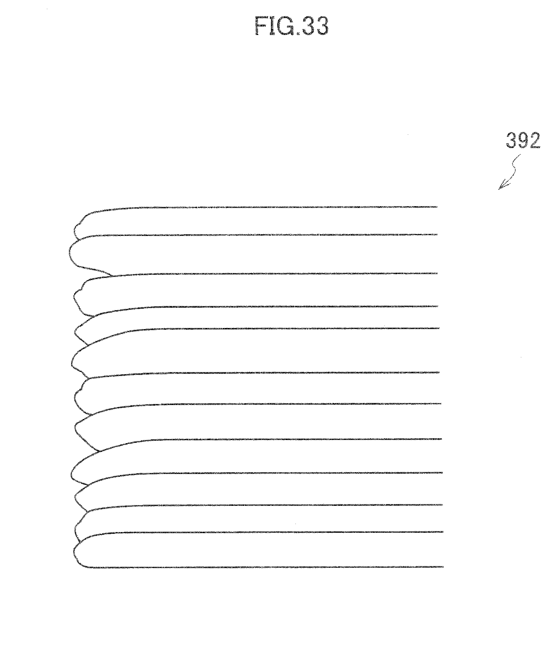

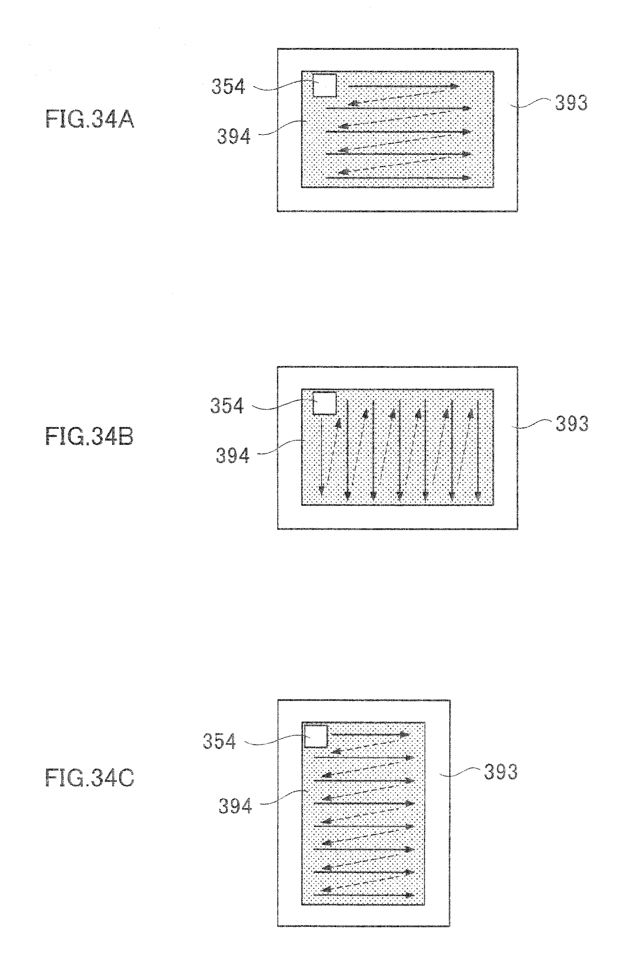

Next, a drawing trace measure will be described with reference to FIGS. 33 and 34.

Regardless of which of the draw-mixing method or the draw-mixing method described above is applied, when a quick-drying fluid is used, a drawing trace may possibly occur on a layer on which the fluid has been discharged.

FIG. 33 shows an example in which an organic solvent-based ink with a boiling point of around 160°C is used and in which a functional fluid layer 392 is formed by discharging a fluid from a single nozzle on a base material heated to around 60°C in a raster scan manner from left to right and then from top to bottom in the drawing. When discharge to a single row is followed by discharging to an immediately lower row in this manner, if a quick-drying fluid has been used, drying of the already-discharged row may create a drawing trace when drawing a next row.

When such a drawing trace occurs, anisotropy of the functional fluid layer 392 due to a direction of the drawing trace increases, which is not favorable as a graded functional material.

Changing scanning directions of a head and a base material is effective in reducing such anisotropy.

FIG. 34A is a schematic view showing a relationship of relative movement between an ink-jet head 354 and a region 394 of a functional fluid layer that is formed on a base material 393. The ink-jet head 354 and the base material 393 are relatively moved as depicted by arrows in FIG. 34A while a functional fluid is being discharged from the ink-jet head 354 to form a pattern (layer) in the region 394. In the case of the device shown in FIG. 4, the stage 30 is moved by the stage controller 43.

At this point, if the functional fluid discharged from the ink-jet head 354 dries quickly, a drawing trace occurs on a functional fluid layer in the region 394 shown in FIG. 33.

Therefore, after discharge of the fluid to the region 394 is completed, a direction of relative movement is changed by 90 degrees as shown in FIG. 34B and the fluid is once again discharged to the region 394. In the case of the device shown in FIG. 4, a movement direction of the stage 30 may be changed by the stage controller 43.

Moreover, as shown in FIG. 34C, after changing a direction of the base material 393 by 90 degrees, the fluid may once again be discharged to the region 394 by a raster scan method in a similar direction. In the case of the device shown in FIG. 4, after rotating the stage 30 by 90 degrees, the fluid may be discharged while performing a relative movement in a same direction as that shown in FIG. 34A.

The same holds true for a device configured so that the ink-jet head 354 moves instead of the base material 393, wherein a movement direction of the ink-jet head 354 may be changed or the stage 30 may be rotated by 90 degrees without changing the movement direction of the ink-jet head 354.

In this manner, by discharging a fluid while performing a relative movement and then further discharging the fluid while performing a relative movement in a direction that differs by 90 degrees to form a single layer, anisotropy can be reduced even when a drawing trace occurs. Moreover, while a direction of relative movement has been changed by 90 degrees in this case, changing directions by approximately 90 degrees may suffice.

(Application example of graded composition via different component)

The source wiring 3 and the like described in the first and second embodiment and the pad 322 described in the other embodiment may have a graded composition using a plurality of metal nanoparticles. Normally, since Au is a metal that is difficult to oxidize and is stable and soft, Au is used as a top surface (outermost surface) of the electrical wiring 321 and the pad 322. However, Au has an disadvantage of being expensive.

On the other hand, Cu is suitable for a film that is formed on an electrode of an IC chip due to its inexpensiveness and high conductivity and is currently being widely used as a material for surface mounted wiring. Adopting a Cu film is also advantageous since Cu has greater migration resistance than Au. However, Cu has a disadvantage of being susceptible to oxidation and is therefore unsuitable as a top surface of the electrical wiring 321 and the pad 322.

in consideration thereof, the electrical wiring 321 and the pad 322 may be configured so that, from a base material side to a top surface, a composition is graded from a conductive polymer to copper and then from copper to gold.

A specific example will be described below in which, with respect to forming the pad 322, two or more types of metal nanoparticles are used and each component is configured so as to have a graded composition.

In such a case, for example, when conductivity is gradually varied, each layer may be formed via a different component such as Ag → Au → Pt → Ti. As shown, even a graded functional material containing many components can be generated using the present invention.

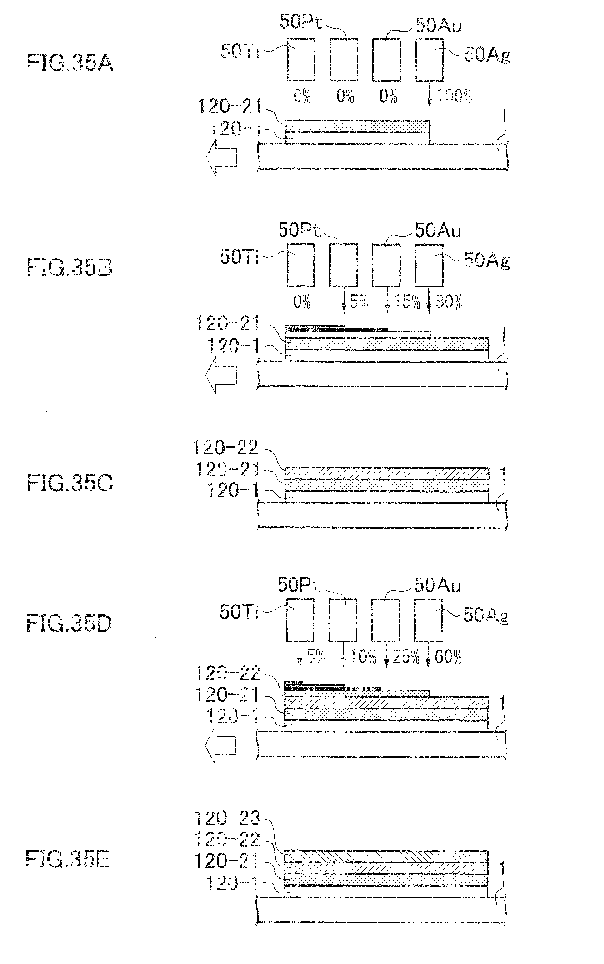

FIGS. 35A to 35E are explanatory diagrams schematically illustrating a mode in which a graded functional material including four components is generated. Ag, Au, Pt, and Ti are used as the four components, and a Ag nanoparticle fluid, a Au nanofluid, a Pt nanoparticle fluid, and a Ti nanoparticle fluid are respectively discharged from an ink-jet head 50Ag, an ink-jet head 50Au, an ink-jet head 50Pt, and an ink-jet head 50Ti.

FIG. 35A schematically illustrates a Ag nanoparticle fluid layer forming step in which a Ag nanoparticle fluid layer 120-21 made of a Ag nanoparticle fluid is formed on top of a conductive polymer fluid layer 120-1 that is a lowermost layer. In the Ag nanoparticle fluid layer forming step, a Ag nanoparticle fluid is discharged from the ink-jet head 50Ag while no fluids are discharged from the ink-jet head 50Au, the ink-jet head 50Pt, and the ink-jet head 50Ti.

FIG. 35B schematically illustrates a step of forming a mixed layer 120-22 on a surface of the Ag nanoparticle fluid layer 120-21. The respective fluids are discharged at a ratio of 80% Au nanoparticle fluid, 15% Ag nanofluid, 5% Pt nanoparticle fluid, and 0% Ti nanoparticle fluid, and the respective fluids are sufficiently diffused and mixed.

FIG. 35C schematically illustrates a state where a mixed layer (a mixed layer containing a Ag nanoparticle fluid, a Au nanofluid, a Pt nanoparticle fluid, and a Ti nanoparticle fluid at a mixture ratio of 80:15:5:0) is formed on top of the Ag nanoparticle fluid layer 120-21.

FIG. 35D schematically illustrates a step of forming a mixed layer 120-23 (refer to FIG. 35E) that is laminated on the mixed layer 120-22 formed earlier.

In the mixed layer forming step shown in FIG. 35D, respective fluids are discharged at a ratio of 60% Au nanoparticle fluid, 25% Ag nanofluid, 10% Pt nanoparticle fluid, and 5% Ti nanoparticle fluid, and the respective fluids are sufficiently diffused and mixed.

FIG. 35E schematically illustrates a state where the mixed layer 120-23 with a different mixture ratio from the mixed layer 120-22 is laminated on the mixed layer 120-22. In this manner, a graded functional material is formed by appropriately varying a mixture ratio of the four types of fluids.

Moreover, a mode where an uppermost layer and a lowermost layer of the graded functional material are mixed layers or a mode where a mixture ratio of all components does not monotonically increase or monotonically decrease (for example, a mode where a part of the components have a fixed mixture ratio or a mode including both increasing and decreasing mixture ratios) can also be adopted.

While a mode where a graded functional material using four (three or more) components is formed according to the draw-mixing method has been exemplified in FIGS. 35A to 35E, it is obvious that a graded functional material can also be formed according to the ink-mixing method using three or more types of components.

Moreover, a fluid repellency treatment may be applied to an outside of the pad 322 when forming the pad 322. Specific examples of a fluid repellency treatment include a mode in which a laser beam is irradiated in an inert gas atmosphere.

A plurality of inks corresponding to the plurality of components that make up the graded functional material may be applied in a descending order or surface tension (surface energy). When a fluid with a relatively low surface tension is applied first and a fluid with a relatively high surface tension is applied subsequently, the subsequently-applied fluid with a relatively high surface tension is not sufficiently diffused and mixed and a component distribution occurs within a layer.

In addition, although not illustrated, by drawing a subsequently-applied fluid in a closest packing (hexagon), a period of time required for diffusion and mixing can be reduced.

(Application example to another device configuration)

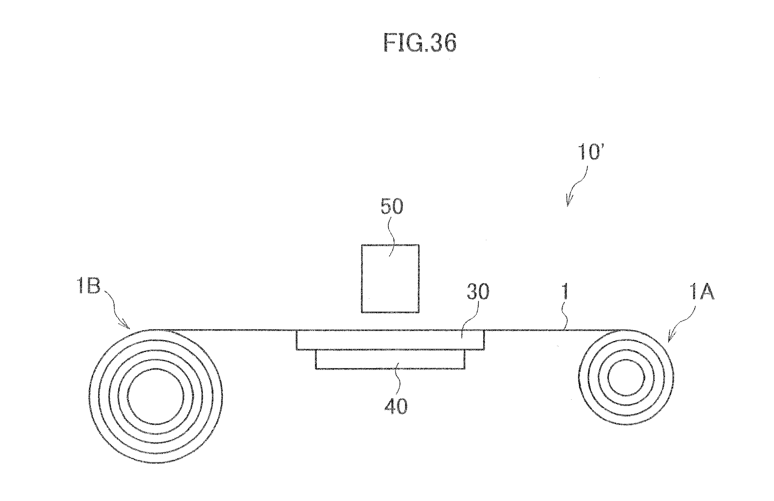

FIG. 36 is a configuration diagram showing a schematic configuration of a conductive pattern forming system 10' according to an application example to another device configuration. Moreover, portions in FIG. 36 that are same as or similar to those already described are denoted by same reference numerals and descriptions thereof will be omitted.

A conductive pattern forming system 1' shown in FIG. 36 adopts a so-called roll-to-roll system in which a flexible film 1 is drawn out from a roll 1A around which the flexible film 1 is wound and reeled in by a roll 1B after an organic TFT (not illustrated in FIG. 36; refer to FIG. 1) and a conductive pattern (not illustrated in FIG. 36; the source wiring 3, the drain wiring 4, and the like in FIG. 1) are formed.

The conductive pattern forming method and system described above are applicable as a method of manufacturing a conductive pattern structure as well as a system (device) for manufacturing a conductive pattern structure. In addition, components can be modified, added, and deleted as appropriate without departing from the spirit and scope of the present invention.

[Appendix]

As is understood from the detailed description of the embodiments of the invention given above, the present specification encompasses a disclosure of various technical ideas which at least include modes described below.

(First Mode): A conductive pattern forming method, comprising the steps of: forming a first pattern on a base material by discharging, from a first ink-jet head, a first functional fluid containing a conductive polymer or containing the conductive polymer and metal microparticles at a predetermined content ratio; forming a second pattern on the first pattern by discharging, from a second ink-jet head, a second functional fluid which contains the conductive polymer and the metal microparticles and in which a content ratio of the conductive polymer is reduced and a content ratio of the metal microparticles is increased with respect to the first functional fluid; and forming a third pattern on the second pattern by discharging, from a third ink-jet head, a third functional fluid which contains the conductive polymer and the metal microparticles and in which the content ratio of the conductive polymer is reduced and the content ratio of the metal microparticles is increased with respect to the second functional fluid, wherein a conductive pattern is formed which at least includes the first pattern, the second pattern, and the third pattern and which has a graded composition in which the content ratio of the conductive polymer is reduced and the content ratio of the metal microparticles is increased from the base material with respect to a thickness direction using three or more types of functional fluids which have different content ratios of the conductive polymer and the metal microparticles.

According to this mode, since a conductive pattern having a graded composition structure in which a content ratio of a conductive polymer decreases while a content ratio of metal microparticles increases from a base material is formed with respect to a thickness direction, adhesion with the base material is secured at a bonding portion between the base material and a conductive pattern due to a high content ratio of the conductive polymer and, at the same time, favorable electrical performance is produced by increasing the content ratio of the metal microparticles.

(Second Mode): The conductive pattern forming method, wherein the conductive pattern is an electrical wiring formed on the base material.

An electrical wiring according to this mode includes a conductive pattern that electrically connects an electronic device or the like formed on a base material.

(Third Mode): The conductive pattern forming method, wherein the conductive pattern is an electrical wiring having a width that corresponds to a diameter of a dot that constitutes the conductive pattern.

A dot diameter according to this mode is favorably a value in a state where a shape of a droplet landed on a base material has stabilized.

(Fourth Mode): The conductive pattern forming method, wherein the conductive pattern is an electrode with a structure where a plurality of electrical wirings having a width that corresponds to a diameter of a dot that constitutes the conductive pattern are connected in a width direction of the electrical wirings.

According to this mode, an electrode may be formed by connecting electrical wirings with a favorable minute width in a width direction of the electrical wirings.

An electrode according to this mode includes conductive patterns referred to as a pad, a land, and a bump.

(Fifth Mode): The conductive pattern forming method, wherein the functional fluid includes a low-boiling-point solvent with a boiling point equal to or higher than 75°C and equal to or lower than 105°C.

According to this mode, evaporation of a solvent in a droplet (dot) of a functional fluid on a base material is promoted, spreading of a pattern is suppressed, and a favorable minute electrical wiring is formed.

(Sixth Mode): The conductive pattern forming method, wherein the functional fluid includes a high-boiling-point solvent with a boiling point equal to or higher than 190°C and equal to or lower than 290°C.

According to this mode, favorable fluid discharge by an ink-jet method is realized and, at the same time, drying of a pattern (dot) of a functional fluid is optimized.

(Seventh Mode): The conductive pattern forming method, wherein the base material is heated to 45°C or higher and 75°C or lower when forming the pattern of the functional fluid.

According to this mode, by heating a base material, wet-spreading of a functional fluid on the base material is suppressed.

(Eighth Mode): The conductive pattern forming method, wherein when forming a pattern of the functional fluid, a relationship among a diameter $D_1$ of a fluid discharged from the ink-jet head, a diameter $D_2$ of a dot of the fluid landed on the base material and after a shape of the dot has stabilized, and a dot pitch W between dots formed on the base material satisfies the following expression: $D_1 < W < D_2$.

According to this mode, a conductive pattern may be formed which has a favorable minute width and in which occurrences of jaggies and bulges are avoided.

(Ninth Mode): The conductive pattern forming method, wherein a relationship between the dot diameter $D_2$ and the dot pitch W satisfies the following expression: $W \leq D_2/2$.

According to this mode, a conductive pattern having a uniform minute width may be further formed.

(Tenth Mode): The conductive pattern forming method, wherein the conductive pattern is an electrode formed on the base material.

An electrode according to this mode is a conductive pattern having a width that exceeds a width of an electrical wiring with a minute width and includes conductive patterns referred to as a pad, a land, and a bump.

(Eleventh Mode): The conductive pattern forming method, wherein the electrode has a width that exceeds a diameter of a dot constituting the conductive pattern.

An electrode according to this mode favorably has a width equal to or greater than twice the dot diameter.

(Twelfth Mode): The conductive pattern forming method, wherein the pattern of the functional fluid is formed while relatively moving the base material and the ink-jet head a plurality of times, and the functional fluid is discretely arranged by a single relative movement of the base material and the ink-jet head, and spaces between the discretely-arranged functional fluid are interpolated by the plurality of relative movements of the base material and the ink-jet head.

According to this mode, landing interference upon landing of a functional fluid on a base material is prevented. In addition, an occurrence of a coffee stain in which a layer deforms in a ring-like shape due to deformation of a shape of the functional fluid (dot) may be prevented.

(Thirteenth Mode): The conductive pattern forming method, further comprising a step of semi-drying the formed pattern.

According to this mode, diffusion occurs in a vicinity of a boundary between respective patterns and adhesion between the respective patterns can be improved.

(Fourteenth Mode): The conductive pattern forming method, wherein drying is slowed down in the semi-drying step when the formed layer dries quickly.

According to this mode, even when a fluid that dries quickly is used, a favorable semi-dried state may be realized.

(Fifteenth Mode): The conductive pattern forming method, further comprising a step of measuring a degree of dryness of the formed pattern, wherein the semi-drying step is performed based on the measured degree of dryness.

According to this mode, even in a case where a functional fluid that dries quickly is used, the functional fluid can be placed in a semi-dried state by suppressing progress of drying and diffusion in a vicinity of a boundary between respective layers can be promoted.

(Sixteenth Mode): The conductive pattern forming method, further comprising, after a previous pattern formation and before a next pattern formation, a step of applying an auxiliary fluid that promotes diffusion of the conductive polymer and the metal microparticles in a mixed fluid.

According to this mode, adhesion between a layer formed first and a layer formed subsequently is strengthened.

(Seventeenth Mode): The conductive pattern forming method, wherein the first pattern is formed by a first functional fluid which contains the conductive polymer and which does not contain the metal microparticles.

According to this mode, a bonding performance and flexibility of a conductive polymer are more effectively produced.

(Eighteenth Mode): The conductive pattern forming method, further comprising, after formation of a pattern of the functional fluid, a step of imparting an outer peripheral portion of the formed pattern with fluid repellency to the functional fluid to be discharged next.

According to this mode, a functional fluid that is discharged next can be prevented from protruding from a lower layer.

(Nineteenth Mode): The conductive pattern forming method, further comprising, after formation of a pattern of the functional fluid, a step of providing an outer peripheral portion of the formed pattern with a frame for enclosing the functional fluid to be discharged next.

According to this mode, a functional fluid that is discharged next can be prevented from protruding from a lower layer.

(Twentieth Mode): The conductive pattern forming method, further comprising a step of imparting lyophilic properties to a surface of the base material with respect to the functional fluid to be discharged first.

According to this mode, wettability of a functional fluid that is discharged first on a base material can be improved.

(Twenty-first Mode): The conductive pattern forming method, wherein each of the steps is performed in an inert gas atmosphere.

According to this mode, a layer that is first formed directly on a base material can be appropriately formed.

(Twenty-second Mode): A conductive pattern forming system, comprising: a plurality of ink-jet heads including a first ink-jet head that discharges a first functional fluid containing a conductive polymer or containing the conductive polymer and metal microparticles at a predetermined content ratio, a second ink-jet head that discharges a second functional fluid which contains the conductive polymer and the metal microparticles and in which a content ratio of the conductive polymer is reduced and a content ratio of the metal microparticles is increased with respect to the first functional fluid, and a third ink-jet head that discharges a third functional fluid which contains the conductive polymer and the metal microparticles and in which the content ratio of the conductive polymer is reduced and the content ratio of the metal microparticles is increased with respect to the second functional fluid, the plurality of ink-jet heads respectively corresponding to three or more types of functional fluids with different content ratios of the conductive polymer and the metal microparticles; and a discharge control device which controls discharge by the plurality of ink-jet heads so as to form a conductive pattern which at least includes a first pattern formed on the base material by discharging the first functional fluid from the first ink-jet head, a second pattern formed on the first pattern by discharging the second functional fluid from the second ink-jet head, and a third pattern formed on the second pattern by discharging the third functional fluid from the third ink-jet head, the conductive pattern having a graded composition in which the content ratio of the conductive polymer is reduced and the content ratio of the metal microparticles is increased from the base material with respect to a thickness direction using three or more types of functional fluids having different content ratios of the conductive polymer and the metal microparticles.

This mode favorably includes a device that respectively realizes the second to twenty-first modes.

(Twenty-third Mode): A conductive pattern forming method, comprising the steps of: forming a first pattern using a conductive polymer fluid containing a conductive polymer and discharged from a first ink-jet head, or a fluid in which the conductive polymer fluid discharged from the first ink-jet head and a metal microparticle fluid which contains metal microparticles and is discharged from a second ink-jet head are mixed at a predetermined content ratio; forming a second pattern on the first pattern using a fluid in which a content ratio of the conductive polymer fluid is reduced and a content ratio of the metal microparticle fluid is increased with respect to the fluid used for formation of the first pattern by discharging the conductive polymer fluid from the first ink-jet head and discharging the metal microparticle fluid from the second ink-jet head; and forming a third pattern on the second pattern using a fluid in which the content ratio of the conductive polymer fluid is reduced and the content ratio of the metal microparticle fluid is increased with respect to the fluid used for formation of the second pattern by discharging the conductive polymer fluid from the first ink-jet head and discharging the metal microparticle fluid from the second ink-jet head, wherein a conductive pattern is formed which at least includes the first pattern, the second pattern, and the third pattern and which has a graded composition in which the content ratio of the conductive polymer fluid is reduced and the content ratio of the metal microparticle fluid is increased from the base material with respect to a thickness direction using three or more types of functional fluids which have different content ratios of the conductive polymer fluid and the metal microparticle fluid.

According to this mode, the number of types of functional fluids can be reduced while obtaining a similar effect as the conductive pattern forming method according to the first mode.

(Twenty-fourth Mode): The conductive pattern forming method, wherein the conductive pattern is an electrical wiring formed on the base material.

(Twenty-fifth Mode): The conductive pattern forming method, wherein the conductive pattern is an electrical wiring having a width that corresponds to a diameter of a dot that constitutes the conductive pattern.

(Twenty-sixth Mode): The conductive pattern forming method, wherein the conductive pattern is an electrode with a structure where a plurality of electrical wirings having a width that corresponds to a diameter of a dot that constitutes the conductive pattern are connected in a width direction of the electrical wirings.

(Twenty-seventh Mode): The conductive pattern forming method, wherein a fluid that is discharged first among the conductive polymer fluid and the metal microparticle fluid is arranged so that adjacent dots overlap each other, and a fluid with a lower content ratio is arranged at a position midway between the adjacent dots formed by the first-discharged fluid.

According to this mode, a favorable mixture state of a conductive polymer fluid and a metal microparticle fluid is created and a favorable minute pattern that is free of jaggies and bulges is formed.

(Twenty-eighth Mode): The conductive pattern forming method, wherein a same dot arrangement condition as the first pattern is applied to the formed pattern.

According to this mode, a favorable laminated pattern may be formed.

(Twenty-ninth Mode): The conductive pattern forming method, wherein among the conductive polymer fluid and the metal microparticle fluid, a fluid with a lower content ratio is discharged before a fluid with a higher content ratio.

According to this mode, a favorable mixture state of a conductive polymer fluid and a metal microparticle fluid can be obtained.

(Thirtieth Mode): The conductive pattern forming method, wherein among the conductive polymer fluid and the metal microparticle fluid, a fluid with a greater surface tension is discharged before a fluid with a smaller surface tension.

According to this mode, a favorable mixture state of a conductive polymer fluid and a metal microparticle fluid can be obtained.

(Thirty-first Mode): The conductive pattern forming method, wherein at least one of the conductive polymer fluid and the metal microparticle fluid includes a low-boiling-point solvent with a boiling point equal to or higher than 75°C and equal to or lower than 105°C.

According to this mode, evaporation of a solvent in a droplet (dot) of a functional fluid on a base material is promoted, spreading of a pattern is suppressed, and a favorable minute electrical wiring is formed.

(Thirty-second Mode): The conductive pattern forming method, wherein at least one of the conductive polymer fluid and the metal microparticle fluid includes a high boiling-point solvent with a boiling point equal to or higher than 190°C and equal to or lower than 290°C.

(Thirty-third Mode): The conductive pattern forming method, wherein the base material is heated to 45°C or higher and 75°C or lower when forming the pattern of at least one of the conductive polymer fluid and the metal microparticle fluid.

According to this mode, favorable fluid discharge by an ink-jet method is realized and, at the same time, drying of a pattern (dot) of a functional fluid is optimized.

(Thirty-fourth Mode): The conductive pattern forming method, wherein when forming a pattern of at least one of the conductive polymer fluid and the metal microparticle fluid, a relationship among a diameter $D_1$ of a fluid discharged from the ink-jet head, a diameter $D_2$ of a dot of the fluid landed on the base material and after a shape of the dot has stabilized, and a dot pitch W between dots formed on the base material satisfies the following expression: $D_1 < W < D_2$.

According to this mode, a conductive pattern may be formed which has a favorable minute width and in which occurrences of jaggies and bulges are avoided.

(Thirty-fifth Mode): The conductive pattern forming method, wherein a relationship between the dot diameter $D_2$ and the

dot pitch W satisfies the following expression: $W \leq D_2/2$.

According to this mode, a conductive pattern having a uniform minute width may be further formed.

(Thirty-sixth Mode): The conductive pattern forming method, wherein the conductive pattern is an electrode formed on the base material.

(Thirty-seventh Mode): The conductive pattern forming method, wherein the electrode has a width that exceeds a diameter of a dot constituting the conductive pattern.

(Thirty-eighth Mode): The conductive pattern forming method, wherein in pattern formation of the conductive polymer fluid and the metal microparticle fluid, the conductive polymer fluid is intermittently discharged and discretely arranged, the metal microparticle fluid is intermittently discharged at a same position as the discretely-arranged conductive polymer fluid, the conductive polymer fluid is discharged so as to interpolate spaces among the discretely-arranged conductive polymer fluid after the metal microparticle fluid is intermittently discharged, and the metal microparticle fluid is discharged at a same position as the conductive polymer fluid that has been discharged so as to interpolate spaces among the discretely-arranged conductive polymer fluid.

According to this mode, by preventing landing interference upon landing of a functional fluid on a base material, an occurrence of a coffee stain in which a layer deforms in a ring-like shape due to deformation of a shape of the functional fluid (dot) caused by landing interference may be prevented.

(Thirty-ninth Mode): The conductive pattern forming method, wherein in pattern formation of the conductive polymer fluid and the metal microparticle fluid, a fluid is discharged from one ink-jet head among the first ink-jet head and the second ink-jet head to a droplet landing position of a fluid discharged from another ink-jet head among the first ink-jet head and the second ink jet.

According to this mode, diffusion and mixing of a conductive polymer fluid and a metal microparticle fluid are promoted.

(Fortieth Mode): The conductive pattern forming method, further comprising a step of applying an auxiliary fluid before discharge by the first ink-jet head and the second ink-jet head.

According to this mode, diffusion and mixing of a conductive polymer fluid and a metal microparticle fluid within a layer are promoted. In addition, diffusion at a boundary with an already-formed layer is promoted.

A solvent component of a conductive polymer fluid or a metal microparticle fluid can be used as an auxiliary fluid according to this mode.

(Forty-first Mode): The conductive pattern forming method, further comprising a step of applying an auxiliary fluid between discharge by the first ink-jet head and discharge by the second ink-jet head.

According to this mode, diffusion and mixing of a conductive polymer fluid and a metal microparticle fluid within a layer are promoted.

(Forty-second Mode): The conductive pattern forming method, further comprising a step of applying an auxiliary fluid after discharge by the first ink-jet head and the second ink-jet head.

According to this mode, diffusion and mixing of a conductive polymer fluid and a metal microparticle fluid within a layer are promoted. In addition, diffusion at a boundary with a next-formed layer is promoted.

(Forty-third Mode): The conductive pattern forming method, further comprising a step of performing property modification on a surface of the base material to which the conductive polymer fluid or the metal microparticle fluid is applied, wherein when forming a pattern made up of the conductive polymer fluid and the metal microparticle fluid, a fluid with a smaller content ratio among the conductive polymer fluid and the metal microparticle fluid is discharged first.

According to this mode, favorable wet-spreading of the conductive polymer fluid and the metal microparticle fluid is realized.

(Forty-fourth Mode): The conductive pattern forming method, wherein when forming a pattern made up of the first functional fluid and the second functional fluid, a fluid with a greater content ratio among the conductive polymer fluid and the metal microparticle fluid is discharged first.

According to this mode, since a subsequently-discharged fluid can be mixed in a state where a first-discharged fluid has sufficiently wet-spread, mixing and diffusion are promoted.

(Forty-fifth Mode): The conductive pattern forming method, further comprising a step of diffusing and mixing, on the base material, the conductive polymer fluid discharged from the first ink-jet head and the metal microparticle fluid discharged from the second ink-jet head.

Specific examples of this mode include a mode in which ultrasonic vibration is applied.

(Forty-sixth Mode): A conductive pattern forming system, comprising: a first ink-jet head that discharges a conductive polymer fluid containing a conductive polymer; a second ink-jet head that discharges a metal microparticle fluid which contains metal microparticles; and a discharge control device which controls discharge by the first ink-jet head and the second ink-jet head so as to form a conductive pattern which at least includes a first pattern formed using a conductive polymer fluid containing a conductive polymer and discharged from a first ink-jet head, or a fluid in which the conductive polymer fluid and a metal microparticle fluid containing metal microparticles and discharged from a second ink-jet head are mixed at a predetermined content ratio, a second pattern formed on the first pattern using a fluid in which a content ratio of the conductive polymer fluid is reduced and a content ratio of the metal microparticle fluid is increased with respect to the fluid used for formation of the first pattern by discharging the conductive polymer fluid from the first ink-jet head and discharging the metal microparticle fluid from the second ink-jet head, and a third pattern formed on the second pattern using a fluid in which the content ratio of the conductive polymer fluid is reduced and the content ratio of the metal microparticle fluid is increased with respect to the fluid used for formation of the second pattern by discharging the conductive polymer fluid from the first ink-jet head and discharging the metal microparticle fluid from the second ink-jet head, the conductive pattern having a graded composition in which the content ratio of the conductive polymer is reduced and the content ratio of the metal microparticles is increased from the base material with respect to a thickness direction using three or more types of functional fluids having different content ratios of the conductive polymer and the metal microparticles.

This mode favorably includes a device that realizes respective steps of the twenty-fourth to forty-fifth modes. (Forty-seventh Mode): The conductive pattern forming system, further comprising: a moving device that relatively moves the first ink-jet head and/or the second ink jet and the base material; and a changing device that changes a direction of the relative movement by <u>90 degrees</u>, wherein during relative movement by the moving device, after discharge of ink from the first ink-jet head and the second ink-jet head, the direction of the relative movement is changed by 90 degrees by the changing device and ink is discharged during relative movement performed once again by the moving device.

According to this mode, generation of anisotropy that is attributable to a drawing trace can be prevented. Moreover, while a direction of relative movement has been changed by 90 degrees in this mode, changing directions by approximately 90 degrees may suffice.

It should be understood, however, that there is no intention to limit the invention to the specific forms disclosed, but on the contrary, the invention is to cover all modifications, alternate constructions and equivalents falling within the spirit and scope of the invention as expressed in the appended claims.

**Claims**

1. A conductive pattern forming method (S10-S28), comprising the steps of:

   forming (S22) a first pattern (3) on a base material (1, 2) by discharging, from a first ink-jet head (50), a first functional fluid (3A-3E) containing a conductive polymer or containing the conductive polymer and metal microparticles at a predetermined content ratio;
   forming (S22) a second pattern (3) on the first pattern by discharging, from a second ink-jet head (50), a second functional fluid (3A-3E) which contains the conductive polymer and the metal microparticles and in which a content ratio of the conductive polymer is reduced and a content ratio of the metal microparticles is increased with respect to the first functional fluid; and
   forming (S22) a third pattern (3) on the second pattern by discharging, from a third ink-jet head (50), a third functional fluid (3A-3E) which contains the conductive polymer and the metal microparticles and in which the content ratio of the conductive polymer is reduced and the content ratio of the metal microparticles is increased with respect to the second functional fluid, wherein
   a conductive pattern (3) is formed which at least includes the first pattern (3), the second pattern (3), and the third pattern (3) and which has a graded composition in which the content ratio of the conductive polymer is reduced and the content ratio of the metal microparticles is increased from the base material with respect to a thickness direction using three or more types of functional fluids (3A-3E) which have different content ratios of the conductive polymer and the metal microparticles.

2. The conductive pattern forming method (S10-S28) according to claim 1, wherein the conductive pattern (3) is an electrical wiring (3) formed on the base material (1, 2).

3. The conductive pattern forming method (S10-S28) according to claim 1 or 2, wherein the conductive pattern (3) is an electrical wiring (3) having a width that corresponds to a diameter ($D_2$) of a dot that constitutes the conductive pattern.

4. The conductive pattern forming method (S10-S28) according to claim 3, wherein the conductive pattern (3) is an electrode with a structure where a plurality of electrical wirings having a width that corresponds to a diameter ($D_2$) of a dot that constitutes the conductive pattern are connected in a width direction of the electrical wirings.

5. The conductive pattern forming method (S10-S28) according to any one of claims 1 to 4, wherein the functional fluid (3A-3E) includes a low-boiling-point solvent with a boiling point equal to or higher than 75°C and equal to or lower than 105°C.

6. The conductive pattern forming method (S10-S28) according to any one of claims 1 to 5, wherein the functional fluid (3A-3E) includes a high-boiling-point solvent with a boiling point equal to or higher than 190°C and equal to or lower than 290°C.

7. The conductive pattern forming method (S10-S28) according to any one of claims 1 to 6, wherein the base material is heated to 45°C or higher and 75°C or lower when forming the pattern of the functional fluid (3A-3E).

8. The conductive pattern forming method (S10-S28) according to any one of claims 1 to 7, wherein when forming a pattern of the functional fluid (3A-3E), a relationship among a diameter $D_1$ of a fluid discharged from the ink-jet head, a diameter $D_2$ of a dot of the fluid landed on the base material and after a shape of the dot has stabilized, and a dot pitch W between dots formed on the base material satisfies the following expression:

$$D_1 < W < D_2.$$

9. The conductive pattern forming method (S10-S28) according to claim 8, wherein a relationship between the dot diameter $D_2$ and the dot pitch W satisfies the following expression:

$$W \leq D_2/2.$$

10. The conductive pattern forming method (S10-S28) according to any one of claims 1-9, wherein the conductive pattern (3) is an electrode formed on the base material (1, 2).

11. The conductive pattern forming method (S10-S28) according to claim 10, wherein the electrode has a width that exceeds a diameter of a dot constituting the conductive pattern.

12. The conductive pattern forming method (S10-S28) according to claim 10 or 11, wherein
the pattern of the functional fluid (3A-3E) is formed while relatively moving the base material (1, 2) and the ink-jet head (50) a plurality of times, and
the functional fluid is discretely arranged by a single relative movement of the base material and the ink-jet head, and spaces between the discretely-arranged functional fluid are interpolated by the plurality of relative movements of the base material and the ink-jet head.

13. The conductive pattern forming method (S10-S28) according to any one of claims 1 to 12, further comprising a step of semi-drying the formed pattern.

14. The conductive pattern forming method (S10-S28) according to claim 13, wherein drying is slowed down in the semi-drying step when the formed layer dries quickly.

15. The conductive pattern forming method (S10-S28) according to claim 13 or 14, further comprising a step of measuring a degree of dryness of the formed pattern, wherein
the semi-drying step is performed based on the measured degree of dryness.

16. The conductive pattern forming method (S10-S28) according to any one of claims 1 to 15, further comprising, after a previous pattern formation and before a next pattern formation, a step of applying an auxiliary fluid (125) that promotes diffusion of the conductive polymer and the metal microparticles in a mixed fluid.

17. The conductive pattern forming method (S10-S28) according to any one of claims 1 to 16, wherein the first pattern is formed by a first functional fluid (3A) which contains the conductive polymer and which does not contain the metal microparticles.

18. The conductive pattern forming method (S10-S28) according to any one of claims 1 to 17, further comprising, after formation of a pattern of the functional fluid, a step of imparting an outer peripheral portion (381) of the formed pattern with fluid repellency to the functional fluid to be discharged next.

19. The conductive pattern forming method (S10-S28) according to any one of claims 1 to 18, further comprising, after formation of a pattern of the functional fluid, a step of providing an outer peripheral portion (383) of the formed pattern with a frame for enclosing the functional fluid to be discharged next.

20. The conductive pattern forming method (S10-S28) according to any one of claims 1 to 19, further comprising a step of imparting lyophilic properties to a surface of the base material with respect to the functional fluid to be discharged first.

21. The conductive pattern forming method (S10-S28) according to any one of claims 1 to 20, wherein each of the steps is performed in an inert gas atmosphere.

FIG.1

EP 2 597 694 A2

FIG.2

EP 2 597 694 A2

EP 2 597 694 A2

FIG.3

EP 2 597 694 A2

FIG.4

# FIG.5

EP 2 597 694 A2

# FIG.6

EP 2 597 694 A2

# FIG.7

START — S10

ACQUIRE INFORMATION — S12

SET CONDITIONS — S14

ACQUIRE PATTERN DATA — S16

GENERATE DISCHARGE DATA — S18

HEAT BASE MATERIAL — S20

GENERATE GRADED COMPOSITION PATTERN — S22

PERFORM COMPLETE DRYING — S24

STOP HEATING OF BASE MATERIAL — S26

END — S28

FIG.8A

FIG.8B

FIG.8C

FIG.9A

50

102

D$_1$

104

1

D$_2$

W

FIG.9B

D$_2$

50

104

W

## FIG.10

PATTERN WIDTH

→ FAVORABLE

→ MORE FAVORABLE

ROOM TEMPERATURE
(25°C)          45°C          60°C

SUBSTRATE TEMPERATURE (°C)

## FIG.11

PATTERN WIDTH

$T_1$          $T_2$          $T_3$

BOILING POINT CALCULATED BASED ON MASS RATIO (°C)

FIG.12

PATTERN WIDTH

OCCURRENCE OF JAGGIES

DIAMETER OF
DISCHARGED
DROPLET D₁

DOT DIAMETER
D₂

DOT PITCH W

FIG.13

FIG.14

FIG.15A

100A

FIG.15B

100B

FIG.15C

100C

FIG.16

(a)    (b)    (c)    (d)    (e)

FIG.17

FIG.18

FIG.19A

FIG.19B

FIG.19C

FIG.20A

FIG.20B

FIG.20C

FIG.20D

FIG.21A

FIG.21B

FIG.21C

FIG.21D

FIG.22

FIG.23

FIG.24A

122-1

FIG.24B

122-1
124-1

FIG.24C

122-1
124-1

122-2

FIG.24D

122-1
124u-1
122-2
124-2

FIG.25A

FIG.25B

FIG.26A

120-2
120-1
1

FIG.26B

50-13
125
120-2
120-1
1

FIG.26C

50-12
50-11
122 124
120-2
120-1
1

EP 2 597 694 A2

**FIG.27A**

**FIG.27B**

**FIG.27C**

60

FIG.28A

50-11

122

120-1

1

FIG.28B

50-12

124

120-1

1

FIG.28C

50-13

125

120-1

1

EP 2 597 694 A2

FIG.29A

50-11

122

120-1

1

FIG.29B

50-13

122  125

120-1

1

FIG.29C

50-12

122  124

120-1

1

62

FIG.30A

380-1

381

A

381

380-1

381

A

1

FIG.30B

380-2

381

A

381

380-2

A

381

380-1

381

1

FIG.31A

382-1

383

A          A

383-1        383-1

382-1                1

FIG.31B

382-2

383

A          A

383-1        382-2        383-1

382-1                1

FIG.31C

383-4        382-4        383-4

383-3

383-2        382-3

382-2        383-1

382-1                1

FIG.32A

HEAD FEED
DIRECTION

351

351

351

350

391    390

FIG.32B

HEAD FEED
DIRECTION

351    352    353

351

352

352

391    390

FIG.33

392

FIG.34A

354

394

393

FIG.34B

354

394

393

FIG.34C

354

394

393

FIG.35A

50Pt     50Au

50Ti         50Ag

0%   0%   0%   100%

120-21
120-1

FIG.35B

50Pt     50Au

50Ti         50Ag

0%   5%   15%   80%

120-21
120-1

FIG.35C

120-22
120-21
120-1

FIG.35D

50Pt     50Au

50Ti         50Ag

5%   10%   25%   60%

120-22
120-21
120-1

FIG.35E

120-23
120-22
120-21
120-1

EP 2 597 694 A2

# FIG.36

**REFERENCES CITED IN THE DESCRIPTION**

**Patent documents cited in the description**

- JP 2004302392 A

- JP 6093418 A